(19) Europäisches Patentamt
European Patent Office
Office européen des brevets

(11) **EP 4 481 835 A1**

(12) **EUROPEAN PATENT APPLICATION**
published in accordance with Art. 153(4) EPC

(43) Date of publication:
**25.12.2024   Bulletin 2024/52**

(21) Application number: 23756059.4

(22) Date of filing: **17.01.2023**

(51) International Patent Classification (IPC):
**H01L 31/10** (2006.01)      **H01L 27/146** (2006.01)

(52) Cooperative Patent Classification (CPC):
**H01L 27/146; H01L 31/10;** Y02E 10/549

(86) International application number:
**PCT/JP2023/001179**

(87) International publication number:
**WO 2023/157531 (24.08.2023 Gazette 2023/34)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.02.2022   JP 2022022315**

(71) Applicant: **Panasonic Intellectual Property Management Co., Ltd.
Kadoma-shi, Osaka 571-0057 (JP)**

(72) Inventors:
• **MACHIDA, Shinichi**
  **Kadoma-shi, Osaka 571-0057 (JP)**
• **SHISHIDO, Sanshiro**
  **Kadoma-shi, Osaka 571-0057 (JP)**
• **MATSUKAWA, Nozomu**
  **Kadoma-shi, Osaka 571-0057 (JP)**

(74) Representative: **Grünecker Patent- und Rechtsanwälte
PartG mbB
Leopoldstraße 4
80802 München (DE)**

(54) **PHOTOELECTRIC CONVERSION ELEMENT AND IMAGING DEVICE**

(57)    A photoelectric conversion element includes a photoelectric conversion layer, a first electrode that collects holes produced in the photoelectric conversion layer as signal charges, and a second electrode that collects electrons produced in the photoelectric conversion layer. The photoelectric conversion layer includes three or more quantum dot layers layered onto one another, and each of the three or more quantum dot layers contains quantum dots and surface-modifying ligands modifying the surfaces of the quantum dots. The band gap energy of the quantum dot layer closer to the first electrode is lower than the band gap energy of the quantum dot layer closer to the second electrode in at least one combination of two adjacent quantum dot layers among the three or more quantum dot layers. At the interface between each of the three or more quantum dot layers and a quantum dot layer adjacent to each of the three or more quantum dot layers, at least one of Expression (1) and Expression (2) below is satisfied:

$$E_{i+1}^{CBM} - E_i^{CBM} \geq 0 \qquad (1)$$

$$E_{i+1}^{VBM} - E_i^{VBM} \geq 0 \qquad (2).$$

FIG. 7A

**Description**

Technical Field

The present disclosure relates to a photoelectric conversion element and an imaging apparatus.

Background Art

Photoelectric conversion elements using semiconductor quantum dots as a photoelectric conversion material based on the quantum size effect are being actively studied. Semiconductor quantum dots refer to nanocrystals, which are semiconductor microcrystals a few nanometers in size. The confinement of electrons, holes, and excitons within the nanocrystals discretizes the energy state, and the resulting particle-size-dependent energy shift is called the quantum size effect. The smaller the particle size is, the more that the band gap energy of the semiconductor quantum dots, that is, nanocrystals, is higher than the band gap energy of the bulk crystal, and thus the absorption end wavelength shifts to the short wavelength side. In other words, controlling the particle size for the same semiconductor material would make it possible to design the light absorption wavelength to any desired wavelength up to the absorption end wavelength of the bulk crystal. Hereinafter, "semiconductor quantum dots" may simply be referred to as "quantum dots" in some cases. In the case of using quantum dots as a photoelectric conversion material, a widened sensitivity wavelength region is desirable to suit the application.

NPL 1 discloses solar cells in which the sensitivity wavelength region can be widened by layering quantum dots with different particle sizes to form a photoelectric conversion layer.

Citation List

Non Patent Literature

NPL 1: Bo Hou et al., "Highly Monodispersed PbS Quantum Dots for Outstanding Cascaded-Junction Solar Cells", ACS Energy Lettes, American Chemical Society, 2016, Vol. 1, pp. 834-839
NPL 2: Patrick R. Brown et al., "Energy Level Modification in Lead Sulfide Quantum Dot Thin Films through Ligand Exchange", ACS Nano, American Chemical Society, 2014, Vol. 8, No. 6, pp. 5863-5872

Summary of Invention

Technical Problem

However, although NPL 1 discloses widening of the sensitivity wavelength band in the case of using quantum dots as a photoelectric conversion material, NPL 1 does not disclose an appropriate layered structure for sensitivity, dark current, and response speed, which are important when using quantum dots in the photoelectric conversion layer of an imaging apparatus or the like. For example, in an imaging apparatus, sensitivity and dark current are directly linked to the signal/noise (S/N) ratio. Also, the response speed required of photoelectric conversion elements used in imaging apparatuses is faster than the response speed of solar cells.

An objective of the present disclosure is to provide a photoelectric conversion element and an imaging apparatus capable of achieving both an expansion of the sensitivity wavelength region and an improvement in sensitivity in the case of using quantum dots in a photoelectric conversion layer.

Solution to Problem

A photoelectric conversion element according to one aspect of the present disclosure includes a photoelectric conversion layer, a first electrode that collects holes produced in the photoelectric conversion layer as signal charges, and a second electrode that faces the first electrode across the photoelectric conversion layer and that collects electrons produced in the photoelectric conversion layer. The photoelectric conversion layer includes three or more quantum dot layers layered onto one another, and each of the three or more quantum dot layers contains quantum dots and surface-modifying ligands modifying the surfaces of the quantum dots. The band gap energy of the quantum dot layer closer to the first electrode is lower than the band gap energy of the quantum dot layer closer to the second electrode in at least one combination of two adjacent quantum dot layers among the three or more quantum dot layers. The energy relationship at the interface between each of the three or more quantum dot layers and a quantum dot layer adjacent to each of the three or more quantum dot layers satisfies at least one of Expression (1) and Expression (2) below.

$$E_{i+1}^{CBM} - E_i^{CBM} \geq 0 \qquad (1)$$

$$E_{i+1}^{VBM} - E_i^{VBM} \geq 0 \qquad (2)$$

Here, $E_i^{CBM}$ is the energy of the lower end of the conduction band of the i-th quantum dot layer of the three or more quantum dot layers, counting from the first electrode, $E_{i+1}^{CBM}$ is the energy of the lower end of the conduction band of the (i+1)-th quantum dot layer of the three or more quantum dot layers, counting from the first electrode, $E_i^{VBM}$ is the energy of the upper end of the valence band of the i-th quantum dot layer of the three or more quantum dot layers, counting from the first electrode, and $E_{i+1}^{VBM}$ is the energy of the upper end of the valence band of the (i+1)-th quantum dot layer of the three or more quantum dot layers, counting from the first electrode.

A photoelectric conversion element according to one aspect of the present disclosure includes a photoelectric conversion layer, a first electrode that collects electrons produced in the photoelectric conversion layer as signal charges, and a second electrode that faces the first electrode across the photoelectric conversion layer and that collects holes produced in the photoelectric conversion layer. The photoelectric conversion layer includes three or more quantum dot layers layered onto one another, and each of the three or more quantum dot layers contains quantum dots. The band gap energy of the quantum dot layer closer to the first electrode is lower than the band gap energy of the quantum dot layer closer to the second electrode in at least one combination of two adjacent quantum dot layers among the three or more quantum dot layers. The energy relationship at the interface between each of the three or more quantum dot layers and a quantum dot layer adjacent to each of the three or more quantum dot layers satisfies at least one of Expression (4) and Expression (5) below.

$$E_i^{CBM} - E_{i+1}^{CBM} \geq 0 \qquad (4)$$

$$E_i^{VBM} - E_{i+1}^{VBM} \geq 0 \qquad (5)$$

Here, $E_i^{CBM}$ is the energy of the lower end of the conduction band of the i-th quantum dot layer of the three or more quantum dot layers, counting from the first electrode, $E_{i+1}^{CBM}$ is the energy of the lower end of the conduction band of the (i+1)-th quantum dot layer of the three or more quantum dot layers, counting from the first electrode, $E_i^{VBM}$ is the energy of the upper end of the valence band of the i-th quantum dot layer of the three or more quantum dot layers, counting from the first electrode, and $E_{i+1}^{VBM}$ is the energy of the upper end of the valence band of the (i+1)-th quantum dot layer of the three or more quantum dot layers, counting from the first electrode.

Also, an imaging apparatus according to one aspect of the present disclosure includes: a plurality of pixels, each including the above photoelectric conversion element; a signal readout circuit connected to the first electrode; and a voltage supply circuit that supplies a voltage to the second electrode.

Advantageous Effects of Invention

According to an aspect of the present disclosure, both an expansion of the sensitivity wavelength region and an improvement in sensitivity can be achieved.

Brief Description of Drawings

[Fig. 1] Fig. 1 is a cross section schematically illustrating the configuration of a photoelectric conversion element according to Embodiment 1.
[Fig. 2A] Fig. 2A is a cross section schematically illustrating the configuration of another example of a photoelectric conversion element according to Embodiment 1.
[Fig. 2B] Fig. 2B is a diagram illustrating an example of an energy diagram for the photoelectric conversion element illustrated in Fig. 2A.
[Fig. 3] Fig. 3 is a diagram illustrating an example of an energy diagram for a photoelectric conversion layer according to Embodiment 1.
[Fig. 4A] Fig. 4A is a diagram for explaining an energy barrier at the interface between two adjacent quantum dot layers.

[Fig. 4B] Fig. 4B is another diagram for explaining an energy barrier at the interface between two adjacent quantum dot layers.

[Fig. 5] Fig. 5 is a diagram illustrating an example of an energy diagram for a photoelectric conversion layer according to Embodiment 2.

[Fig. 6] Fig. 6 is a diagram illustrating an example of an energy diagram for a photoelectric conversion layer according to Embodiment 3.

[Fig. 7A] Fig. 7A is a diagram illustrating an example of an energy diagram for a photoelectric conversion layer according to Embodiment 4.

[Fig. 7B] Fig. 7B is a diagram schematically illustrating an example of the absorption spectra of quantum dot layers according to Embodiment 4.

[Fig. 7C] Fig. 7C is a diagram for explaining the absorption of light, including the absorption peak wavelength of each quantum dot layer, within the photoelectric conversion layer according to Embodiment 4.

[Fig. 7D] Fig. 7D is a diagram for explaining the absorption of light, including the absorption peak wavelength of each quantum dot layer, within a different photoelectric conversion layer.

[Fig. 8] Fig. 8 is a diagram illustrating an example of an energy diagram for a photoelectric conversion layer according to Embodiment 5.

[Fig. 9] Fig. 9 is a diagram illustrating an example of the circuit configuration of an imaging apparatus according to Embodiment 6.

[Fig. 10] Fig. 10 is a cross section schematically illustrating the device structure of a pixel in the imaging apparatus according to Embodiment 6.

Description of Embodiments

(Overview of present disclosure)

A photoelectric conversion element according to one aspect of the present disclosure includes a photoelectric conversion layer, a first electrode that collects holes produced in the photoelectric conversion layer as signal charges, and a second electrode that faces the first electrode across the photoelectric conversion layer and that collects electrons produced in the photoelectric conversion layer. The photoelectric conversion layer includes three or more quantum dot layers layered onto one another, and each of the three or more quantum dot layers contains quantum dots and surface-modifying ligands modifying the surfaces of the quantum dots. The band gap energy of the quantum dot layer closer to the first electrode is lower than the band gap energy of the quantum dot layer closer to the second electrode in at least one combination of two adjacent quantum dot layers among the three or more quantum dot layers. The energy relationship at the interface between each of the three or more quantum dot layers and a quantum dot layer adjacent to each of the three or more quantum dot layers satisfies at least one of Expression (1) and Expression (2) below.

$$E_{i+1}^{CBM} - E_i^{CBM} \geq 0 \qquad (1)$$

$$E_{i+1}^{VBM} - E_i^{VBM} \geq 0 \qquad (2)$$

Here, $E_i^{CBM}$ is the energy of the lower end of the conduction band of the i-th quantum dot layer of the three or more quantum dot layers, counting from the first electrode, $E_{i+1}^{CBM}$ is the energy of the lower end of the conduction band of the (i+1)-th quantum dot layer of the three or more quantum dot layers, counting from the first electrode, $E_i^{VBM}$ is the energy of the upper end of the valence band of the i-th quantum dot layer of the three or more quantum dot layers, counting from the first electrode, and $E_{i+1}^{VBM}$ is the energy of the upper end of the valence band of the (i+1)-th quantum dot layer of the three or more quantum dot layers, counting from the first electrode.

In this way, at least one of Expression (1) and Expression (2) is satisfied, whereby three or more quantum dot layers are layered so as not to create an energy barrier to the transport of at least one of holes and electrons. Accordingly, the accumulation of charges generated by photoelectric conversion at the interface between specific quantum dot layers can be suppressed. Therefore, the sensitivity of the photoelectric conversion element can be improved.

Also, in at least one combination of two adjacent quantum dot layers, the band gap energy of the quantum dot layer closer to the first electrode is lower than the band gap energy of the quantum dot layer closer to the second electrode, whereby light of the absorption peak wavelength of the quantum dot layer closer to the first electrode of the two adjacent quantum dot layers is absorbed less readily by the quantum dot layer closer to the second electrode. As a result, photoelectric conversion occurs more readily in the quantum dot layer closer to the first electrode where signal charges are collected, and the first electrode collects signal charges more readily. Therefore, the sensitivity of the photoelectric conversion element can be improved. Moreover, since three or more quantum dot layers will include a combination of two adjacent quantum dot layers with different band gap energies, quantum dot layers with different absorption peak wavelengths are layered. Accordingly, the sensitivity wavelength region of the photoelectric conversion element can be expanded.

As above, a photoelectric conversion element according to the present aspect can achieve both an expansion of the sensitivity wavelength region and an improvement in sensitivity.

Additionally, for example, the energy relationship at the interface may satisfy both Expression (1) and Expression (2).

With this arrangement, three or more quantum dot layers are layered so as not to create an energy barrier to the transport of both holes and electrons. Therefore, the sensitivity of the photoelectric conversion element can be improved further.

Additionally, for example, the energy relationship at the interface may satisfy Expression (3) below.

$$E_i^{VBM} - E_{i+1}^{CBM} > 0 \qquad (3)$$

With this arrangement, an energy barrier against thermal excitation is provided at the interface between two adjacent quantum dot layers, thereby suppressing the formation of hole-electron pairs due to thermal excitation irrespective of light incidence. Therefore, dark current can be suppressed in the photoelectric conversion element.

Also, a photoelectric conversion element according to one aspect of the present disclosure includes a photoelectric conversion layer, a first electrode that collects electrons produced in the photoelectric conversion layer as signal charges, and a second electrode that faces the first electrode across the photoelectric conversion layer and that collects holes produced in the photoelectric conversion layer. The photoelectric conversion layer includes three or more quantum dot layers layered onto one another, and each of the three or more quantum dot layers contains quantum dots. The band gap energy of the quantum dot layer closer to the first electrode is lower than the band gap energy of the quantum dot layer closer to the second electrode in at least one combination of two adjacent quantum dot layers among the three or more quantum dot layers. The energy relationship at the interface between each of the three or more quantum dot layers and a quantum dot layer adjacent to each of the three or more quantum dot layers satisfies at least one of Expression (4) and Expression (5) below.

$$E_i^{CBM} - E_{i+1}^{CBM} \geq 0 \qquad (4)$$

$$E_i^{VBM} - E_{i+1}^{VBM} \geq 0 \qquad (5)$$

Here, $E_i^{CBM}$ is the energy of the lower end of the conduction band of the i-th quantum dot layer of the three or more quantum dot layers, counting from the first electrode, $E_{i+1}^{CBM}$ is the energy of the lower end of the conduction band of the (i+1)-th quantum dot layer of the three or more quantum dot layers, counting from the first electrode, $E_i^{VBM}$ is the energy of the upper end of the valence band of the i-th quantum dot layer of the three or more quantum dot layers, counting from the first electrode, and $E_{i+1}^{VBM}$ is the energy of the upper end of the valence band of the (i+1)-th quantum dot layer of the three or more quantum dot layers, counting from the first electrode.

In this way, at least one of Expression (4) and Expression (5) is satisfied, whereby three or more quantum dot layers are layered so as not to create an energy barrier to the transport of at least one of holes and electrons. Accordingly, the accumulation of charges generated by photoelectric conversion at the interface between specific quantum dot layers can be suppressed. Therefore, the sensitivity of the photoelectric conversion element can be improved.

Also, in at least one combination of two adjacent quantum dot layers, the band gap energy of the quantum dot layer closer to the first electrode is lower than the band gap energy of the quantum dot layer closer to the second electrode, whereby light of the absorption peak wavelength of the quantum dot layer closer to the first electrode of the two adjacent quantum dot layers is absorbed less readily by the quantum dot layer closer to the second electrode. As a result, photoelectric conversion occurs more readily in the quantum dot layer closer to the first electrode where signal charges are collected, and the first electrode collects signal charges more readily. Therefore, the sensitivity of the photoelectric conversion element can be improved. Moreover, since three or more quantum dot layers will include a combination of two adjacent quantum dot layers with different band gap energies, quantum dot layers with different absorption peak wavelengths are layered. Accordingly, the sensitivity wavelength region of the photoelectric conversion element can be expanded.

As above, a photoelectric conversion element according to the present aspect can achieve both an expansion of the sensitivity wavelength region and an improvement in sensitivity.

Additionally, for example, the energy relationship at the interface may satisfy both Expression (4) and Expression (5).

With this arrangement, three or more quantum dot layers are layered so as not to create an energy barrier to the transport of both holes and electrons. Therefore, the sensitivity of the photoelectric conversion element can be improved further.

Additionally, for example, the energy relationship at the interface may satisfy Expression (6) below.

$$E_{i+1}{}^{VBM} - E_i{}^{CBM} > 0 \qquad (6)$$

With this arrangement, an energy barrier against thermal excitation is provided at the interface between two adjacent quantum dot layers, thereby suppressing the formation of hole-electron pairs due to thermal excitation irrespective of light incidence. Therefore, dark current can be suppressed in the photoelectric conversion element.

Additionally, for example, in the three or more quantum dot layers, a potential gradient for the signal charges may be equal to or greater than a potential gradient for charges of opposite polarity to the signal charges.

This speeds up the collection of signal charges, enabling the realization of a photoelectric conversion element with enhanced responsiveness to signal charges.

Additionally, for example, out of two adjacent quantum dot layers among the three or more quantum dot layers, the particle diameter of the quantum dots contained in the quantum dot layer closer to the second electrode may be less than the particle diameter of the quantum dots contained in the quantum dot layer closer to the first electrode. In other words, the particle diameter of the quantum dots contained in each of the three or more quantum dot layers may decrease in order from the first electrode side.

This arrangement allows for the easy realization of three or more quantum dot layers in which the band gap energy of the quantum dot layer closer to the first electrode is lower than the band gap energy of the quantum dot layer closer to the second electrode in all combinations of two adjacent quantum dot layers.

Additionally, for example, out of two adjacent quantum dot layers among the three or more quantum dot layers, the absorption peak wavelength of the quantum dot layer closer to the second electrode may be shorter than the absorption peak wavelength of the quantum dot layer closer to the first electrode. In other words, the absorption peak wavelength of each of the three or more quantum dot layers may decrease in order from the first electrode side.

Quantum dot layers also have an absorption wavelength region on the short wavelength side of the absorption peak wavelength, but with this configuration of three or more quantum dot layers, light of the absorption peak wavelength of the quantum dot layer closer to the first electrode is absorbed less readily by the quantum dot layer closer to the second electrode in all combinations of two adjacent quantum dot layers. Therefore, the sensitivity of the photoelectric conversion element can be improved further.

Additionally, for example, each of the three or more quantum dot layers may further contain surface-modifying ligands modifying the surfaces of the quantum dots, and the surface-modifying ligands contained in at least two of the three or more quantum dot layers may be mutually different.

This allows the energy at the upper end of the valence band of a quantum dot layer to be adjusted according to the type of surface-modifying ligands, and thus a quantum dot layer with the desired energy band can be realized easily.

Additionally, for example, each of the three or more quantum dot layers may further contain surface-modifying ligands modifying the surfaces of the quantum dots, and the densities of the surface-modifying ligands contained in at least two of the three or more quantum dot layers may be mutually different.

This allows the energy at the upper end of the valence band of a quantum dot layer to be adjusted according to the density of surface-modifying ligands, and thus a quantum dot layer with the desired energy band can be realized easily.

Additionally, for example, the quantum dots may include at least one selected from the group consisting of CdSe, CdS, PbS, PbSe, PbTe, ZnO, ZnS, $Cu_2ZnSnS_4$, $Cu_2S$, $CuInSe_2$, $AgInS_2$, $AgInTe_2$, $CdSnAs_2$, $ZnSnAs_2$, $ZnSnSb_2$, $Bi_2S_3$, $Ag_2S$, $Ag_2Te$, $AgBiS_2$, AgAuS, HgTe, CdHgTe, Ge, GeSn, InAs, and InSb.

By combining the above, the sensitivity wavelength of the photoelectric conversion element can be freely controlled over a wide wavelength range from visible light to infrared light.

Also, an imaging apparatus according to one aspect of the present disclosure includes: a plurality of pixels, each including the above photoelectric conversion element; a signal readout circuit connected to the first electrode; and a voltage supply circuit that supplies a voltage to the second electrode.

With this arrangement, the imaging apparatus includes the above photoelectric conversion element, and thus can achieve both an expansion of the sensitivity wavelength region and an improvement in sensitivity.

Hereinafter, embodiments of the present disclosure will be described with reference to the drawings.

Note that the embodiments described hereinafter all illustrate general or specific examples. Features such as numerical values, shapes, structural elements, placement and connection states of structural elements, steps, and the ordering of steps indicated in the following embodiments are merely examples, and are not intended to limit the present disclosure. In addition, among the structural elements in the following embodiments, structural elements that are not described in the independent claims are described as arbitrary or optional structural elements. Also, the diagrams are not necessarily exact illustrations. Consequently, for example, the scale and the like may not necessarily be consistent from diagram to diagram. Also, in each diagram, parts of the configuration which are substantially the same are denoted with the same signs, and duplicate description of such parts may be omitted or simplified.

In this specification, terms indicating relationships between elements, terms indicating shapes of elements, and numerical ranges are not expressions that express strict meaning only, but rather are expressions that also include a range of substantial equality, such as a difference of a few percent, for example.

Also, in this specification, the terms "above" and "below" do not refer to the upward direction (vertically above) and the downward direction (vertically below) in absolute spatial perception, but are used as terms defined by relative positional relationships based on the layering order in a layered configuration. Note that terms such as "above" and "below" are merely used to specify the arrangement of members relative to each other, and are not intended to limit the attitude or orientation when the imaging apparatus is used. Moreover, the terms "above" and "below" apply not only when two structural elements are spaced apart from each other at an interval and another structural element exists between the two structural elements, but also when two structural elements are disposed in close contact with each other and the two structural elements are contiguous.

Also, in this specification, the entire electromagnetic spectrum, including visible light, infrared rays, and ultraviolet rays, are designated "light" out of convenience.

(Embodiment 1)

[Overall configuration]

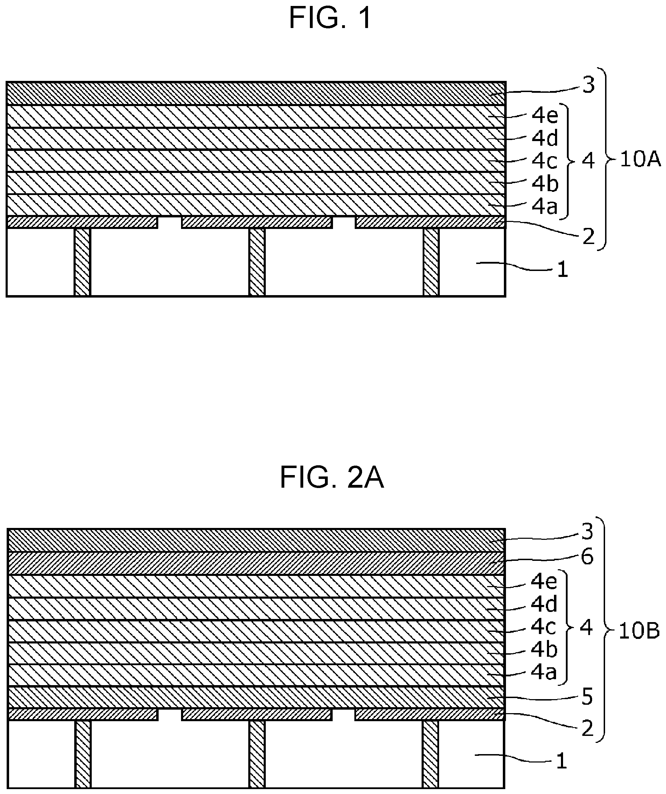

First, the overall configuration of a photoelectric conversion element according to the present embodiment will be described. Fig. 1 is a cross section schematically illustrating the configuration of a photoelectric conversion element 10A according to the present embodiment. As illustrated in Fig. 1, a photoelectric conversion element 10A includes a first electrode 2, a second electrode 3, and a photoelectric conversion layer 4 located between the first electrode 2 and the second electrode 3. To expand the sensitivity wavelength region, the photoelectric conversion layer 4 has n quantum dot layers, and has a structure in which the n quantum dot layers are layered. Here, n is an integer equal to or greater than 3, and the present embodiment describes the case of n=5 as an example. That is, in the present embodiment, the photoelectric conversion layer 4 has a structure in which the five layers of a first quantum dot layer 4a, a second quantum dot layer 4b, a third quantum dot layer 4c, a fourth quantum dot layer 4d, and a fifth quantum dot layer 4e are layered. Note that the number of quantum dot layers included in the photoelectric conversion layer 4 is not particularly limited. For example, n may be equal to or greater than 4, and may also be equal to or greater than 5. The larger the number n is, the more readily is the movement of electrons impeded within the photoelectric conversion layer 4, which makes an improvement in sensitivity more difficult, but in the present disclosure, the sensitivity of the photoelectric conversion element can be improved effectively even when, for example, n is set to be equal to or greater than 4 to further expand the sensitivity wavelength region of the photoelectric conversion element. In addition, n may be less than or equal to 10, and may also be less than or equal to 7.

The five quantum dot layers from the first quantum dot layer 4a to the fifth quantum dot layer 4e have mutually different absorption peak wavelengths, for example. In the photoelectric conversion layer 4, the first quantum dot layer 4a, the second quantum dot layer 4b, the third quantum dot layer 4c, the fourth quantum dot layer 4d, and the fifth quantum dot layer 4e are layered, in that order, from the first electrode 2 side.

Also, the photoelectric conversion element 10A is supported on a substrate 1. In the photoelectric conversion element 10A, the first electrode 2, the photoelectric conversion layer 4, and the second electrode 3 are layered, in that order, on one major surface of the substrate 1.

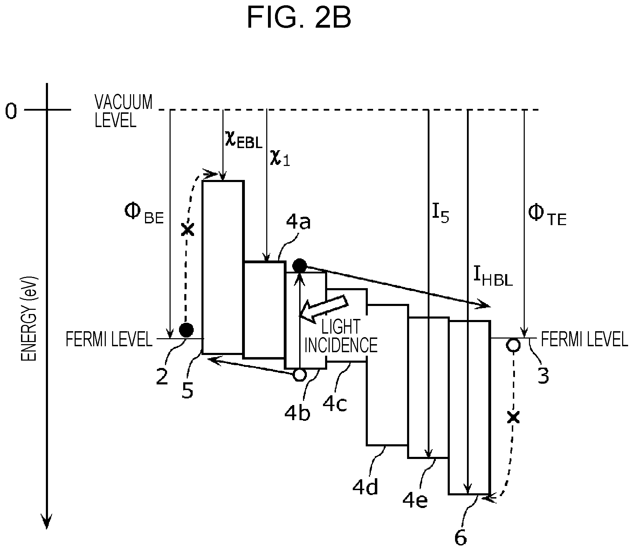

The photoelectric conversion element 10A may further include a charge blocking layer. Fig. 2A is a cross section schematically illustrating the configuration of a photoelectric conversion element 10B, which is another example according to the present embodiment. Fig. 2B is a diagram illustrating an example of an energy diagram for the photoelectric conversion element 10B illustrated in Fig. 2A. In Fig. 2B, the energy band of each layer is illustrated schematically as a rectangle. Fig. 2B is a diagram illustrating that the lower the position is, that is, the greater the difference from the vacuum level is, the higher the energy is. The upper end of a rectangle illustrated in Fig. 2B is the energy of the lower end of the conduction band or lowest unoccupied molecular orbital (LUMO). The lower end of a rectangle illustrated in Fig. 2B is the energy of the upper end of the valence band or highest occupied molecular orbital (HOMO). In Fig. 2B, the difference between the vacuum level and the energy of the lower end of the conduction band or LUMO is the electron affinity, and the difference between the vacuum level and the upper end of the valence band or HOMO is the ionization potential. Also, the difference between the Fermi level and the vacuum level is the work function. Also, the band gap energy is the difference between the energy of the lower end of the conduction band and the energy of the upper end of the valence band, or the difference between the energy of the LUMO and the energy of the HOMO. The same applies to the energy diagrams described hereinafter. Note that one example of an energy diagram for the photoelectric conversion element 10A illustrated in Fig. 1 is expressed by removing the energy bands for the electron blocking layer 5 and the hole blocking layer 6 from Fig. 2B.

As illustrated in Fig. 2A, the photoelectric conversion element 10B includes, in addition to the configuration of the photoelectric conversion element 10A, an electron blocking layer 5 located between the first electrode 2 and the photoelectric conversion layer 4, and a hole blocking layer 6 located between the second electrode 3 and the photoelectric conversion layer 4. In the photoelectric conversion element 10B, the first electrode 2, the electron blocking layer 5, the photoelectric conversion layer 4, the hole blocking layer 6, and the second electrode 3 are layered, in that order, on one major surface of the substrate 1. Although details will be described later, this configuration allows for a reduction in dark current when a reverse bias voltage is applied during photoelectric conversion.

The following description details each component of the photoelectric conversion element according to the present embodiment.

[Substrate]

The substrate 1 is a support substrate that supports the photoelectric conversion element 10A and the photoelectric conversion element 10B. The material of the substrate 1 is not particularly limited, and any of various materials can be used. For example, the substrate may be a p-type silicon substrate on which an insulating layer is formed, or a glass or plastic substrate coated with a conductive metal oxide such as indium tin oxide (ITO) or a conductive polymer such as polyacetylene. The substrate 1 may transmit at least a portion of light at wavelengths that the photoelectric conversion layer 4 absorbs. For example, the substrate 1 is disposed on the opposite side from the light-incident side of the photoelectric conversion element 10A and photoelectric conversion element 10B.

Note that in the example illustrated in the diagram, the substrate 1 is disposed close to the first electrode 2 in the photoelectric conversion element 10A and photoelectric conversion element 10B, but may also be disposed close to the second electrode 3 in the photoelectric conversion element 10A and photoelectric conversion element 10B.

[First electrode and second electrode]

The first electrode 2 and the second electrode 3 are membrane electrodes, for example. The first electrode 2 is an electrode that collects signal charges generated in the photoelectric conversion layer 4. The collected signal charges are stored in, for example, a charge storage unit (not illustrated) via a plug or the like. The second electrode 3 is an electrode that collects charges of opposite polarity to the signal charges generated in the photoelectric conversion layer 4. In the present embodiment, the first electrode 2 is a hole-collecting electrode that collects holes produced in the photoelectric conversion layer 4 as the signal charges. Meanwhile, the second electrode 3 is an electron-collecting electrode that collects electrons as the charges of opposite polarity to the signal charges produced in the photoelectric conversion layer 4. The second electrode 3 is disposed to face the first electrode 2 across the photoelectric conversion layer 4. Also, the second electrode 3 is disposed, for example, on the light-incident side of the photoelectric conversion element 10A and photoelectric conversion element 10B. In this case, light is incident on the photoelectric conversion layer 4 through the second electrode 3. Note that in the examples illustrated in Figs. 1 and 2A, multiple first electrodes 2 are arranged side by side on the major surface of the substrate 1, but the first electrode 2 included in the photoelectric conversion element 10A and the photoelectric conversion element 10B may also be a single electrode.

The second electrode 3 is, for example, a transparent electrode that is highly light-transmissive in a desired wavelength range. The desired wavelength is, for example, a wavelength range of high absorption by the photoelectric conversion layer 4. More specifically, the desired wavelength a wavelength range including at least one absorption peak of the photoelectric conversion layer 4, for example, and may also be a wavelength range including the absorption peak wavelength of each of the n quantum dot layers included in the photoelectric conversion layer 4. Also, in this specification, being highly light-transmissive for a certain wavelength may mean that, for example, the transmittance of light at the certain wavelength is equal to or higher than 50%, and may also mean that the transmittance is equal to or higher than 80%.

A bias voltage is applied to the first electrode 2 and the second electrode 3 by wires (not illustrated), for example. The polarity of the bias voltage is determined such that, for example, out of electron-hole pairs produced in the photoelectric conversion layer 4, the electrons move to the second electrode 3 while the holes move to the first electrode 2. Specifically, a bias voltage is applied such that the potential of the second electrode 3 is positive with respect to the potential of the first electrode 2. With this arrangement, the first electrode 2 collects holes, that is, signal charges, while the second electrode 3 collects electrons, that is, charges of opposite polarity to the signal charges, and flushes the collected electrons to the outside, for example. Also, by making the work function of the second electrode 3 smaller than the work function of the first electrode 2, the first electrode 2 may collect holes and the second electrode 3 may flush electrons under conditions in which there is no potential difference between the first and second electrodes.

A transparent conductive oxide (TCO) with low resistance is used as the material of the transparent electrode, for example. The TCO is not particularly limited, and for example, ITO, indium zinc oxide (InZnO; IZO), aluminum zinc oxide (AlZnO; AZO), fluorine-doped tin oxide (FTO), $SnO_2$, $TiO_2$, $ZnO_2$, or the like can be used. Also, graphene, carbon nanotubes, or the like may also be used as the material of the transparent electrode.

In addition, Al, Cu, Ti, TiN, Ta, TaN, Mo, Ru, In, Mg, Ag, Au, Pt, or the like is used as the material of the first electrode 2, for example. The first electrode 2 may also be a transparent electrode.

[Photoelectric conversion layer]

In the photoelectric conversion layer 4, hole-electron pairs, that is, excitons, are produced due to the incidence of light. To expand the sensitivity wavelength region of the photoelectric conversion element, the photoelectric conversion layer 4 includes quantum dots with different absorption peak wavelengths as the photoelectric conversion material. For example, the n quantum dot layers each include quantum dots with mutually different absorption peak wavelengths. Also, the absorption end of each quantum dot layer on the long wavelength side is determined by the band gap energy of the included quantum dots, for example. Therefore, the absorption peak of each quantum dot layer is also a wavelength that corresponds to the band gap energy of the included quantum dots.

Quantum dots are nanocrystals with diameters approximately from 2 nm to 10 nm, and are formed approximately from tens to thousands of atoms. Quantum dot materials are, for example, Group IV semiconductors such as Si or Ge, Group IV-VI semiconductors such as PbS, PbSe, or PbTe, Group III-V semiconductors such as InAs or InSb, or ternary mixed crystals such as HgCdTe or PbSnTe.

Specifically, for example, the photoelectric conversion layer 4 is formed by layering the five layers from the first quantum dot layer 4a to the fifth quantum dot layer 4e, each of which includes quantum dots with mutually different particle sizes. The absorption peak of quantum dots can be adjusted by altering the particle size for the same material; at smaller particle sizes, the absorption peak wavelength becomes shorter, and conversely, at larger particle sizes, the absorption peak wavelength becomes longer and approaches the absorption end wavelength of the bulk crystal. Each quantum dot layer generates hole-electron pairs by absorbing light.

The absorption peak wavelength of the photoelectric conversion layer 4 may also be adjusted by the constituent element of the quantum dot material. For example, between PbS and PbSe, PbSe has a smaller band gap energy of the bulk crystal, which is characteristic of a longer absorption peak wavelength when used as quantum dots. Consequently, when the particle size is the same, PbSe quantum dots have an absorption peak at a longer wavelength than PbS quantum dots. The quantum dots contained in each of the n quantum dot layers each include at least from among CdSe, CdS, PbS, PbSe, PbTe, ZnO, ZnS, $Cu_2ZnSnS_4$ (CZTS), $Cu_2S$, $Bi_2S_3$, $CuInSe_2$, $AgInS_2$, $AgInTe_2$, $CdSnAs_2$, $ZnSnAs_2$, $ZnSnSb_2$, $Ag_2S$, $Ag_2Te$, $AgBiS_2$, AgAuS, HgTe, HgCdTe, Ge, GeSn, InAs, and InSb, for example. By selecting from among these materials an appropriate combination of materials that absorb at desired wavelengths and adjusting the particle sizes, the sensitivity wavelength of the photoelectric conversion element can be freely controlled over a wide wavelength range from visible light to infrared light.

The photoelectric conversion layer 4 has two or more absorption peaks as a result of including quantum dots with mutually different particle diameters in at least two quantum dot layers among the n quantum dot layers. The particle diameter of the quantum dots contained in each quantum dot layer is a value obtained as the mode diameter that is the maximum value of the distribution when a particle diameter distribution of particles measured by transmission electron microscopy or the like is expressed as a frequency distribution, for example.

Additionally, for quantum dots with the same constituent element, the absorption peak wavelength depends on the particle diameter, and thus the particle diameter of the quantum dots can also be expressed by the absorption peak wavelength. The absorption peak wavelength of quantum dots corresponds to the mode diameter of the quantum dots. Specifically, quantum dots with a smaller band gap energy and a longer absorption peak wavelength have larger particle diameters, whereas quantum dots with a larger band gap energy and a shorter absorption peak wavelength has smaller particle diameters.

The particle size of quantum dots can be controlled by adjusting the reaction time and temperature using existing quantum dot growth methods. Accordingly, for example, it is possible to obtain quantum dots of substantially uniform particle diameter. Quantum dots of uniform particle diameter are quantum dots having a single absorption peak in the near-infrared region, for example. The quantum dots contained in each quantum dot layer are each formed from quantum dots of a single type and of uniform particle diameter, for example.

Each of the n quantum dot layers may also include surface-modifying ligands that modify the surface of the quantum dots. For example, the quantum dots contained in each quantum dot layer may each be covered by mutually different surface-modifying ligands.

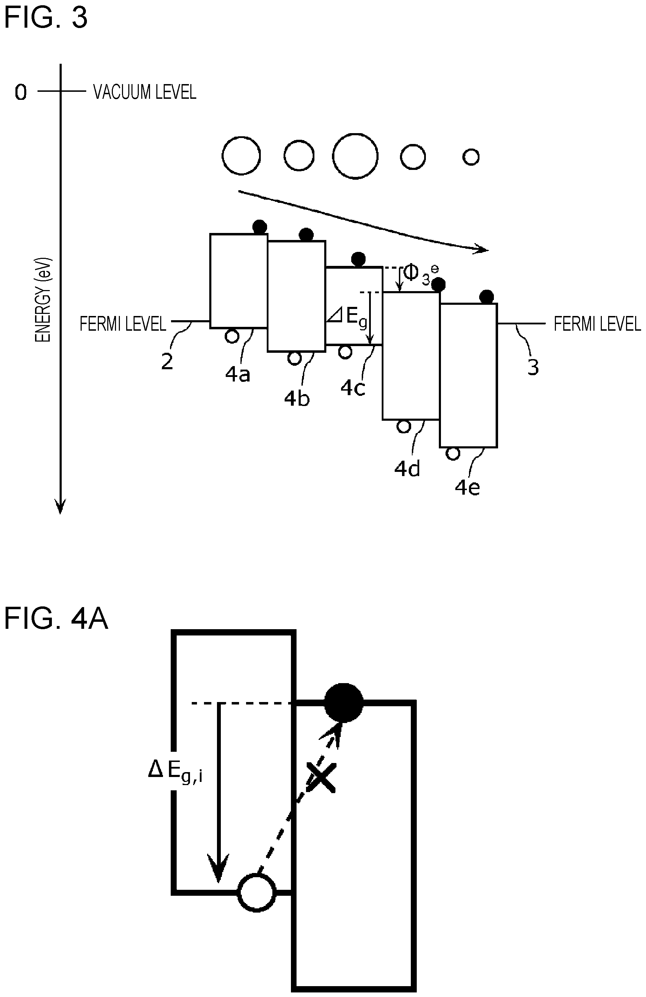

Fig. 3 is a diagram illustrating an example of an energy diagram for a photoelectric conversion layer according to the present embodiment. Fig. 3 illustrates an example of an energy diagram for the case in which five quantum dot layers are layered, the layers containing quantum dots of the same constituent element but mutually different particle diameters. Also, Fig. 3 schematically illustrates the particle size of the quantum dots contained in each quantum dot layer above the energy band of each quantum dot layer.

In the present embodiment, the band gap energy of the quantum dot layer closer to the first electrode 2 is lower than the band gap energy of the quantum dot layer closer to the second electrode 3 in at least one combination of two adjacent quantum dot layers among the n quantum dot layers. Accordingly, in the at least one combination, the absorption peak wavelength of the quantum dot layer closer to the first electrode 2 is longer than the absorption peak wavelength of the quantum dot layer closer to the second electrode 3. Also, in the case where each quantum dot layer includes quantum dots of the same constituent element, in the at least one combination, the particle diameter of the quantum dots contained in the quantum dot layer closer to the first electrode 2 is larger than the particle diameter of the quantum dots included in the quantum dot layer closer to the second electrode 3. Although details will be described later, by causing the n quantum dot layers to have such a band gap energy relationship, light of the absorption peak wavelength of the quantum dot layer closer to the first electrode 2 is absorbed less readily by the quantum dot layer closer to the second electrode 3. As a result, photoelectric conversion occurs more readily in the quantum dot layer closer to the first electrode 2 where signal charges are collected, and the first electrode 2 collects the signal charges more readily. Therefore, the sensitivity of the photoelectric conversion element can be improved.

Moreover, by having the n quantum dot layers include a combination of two adjacent quantum dot layers with different band gap energies, quantum dot layers with different absorption peak wavelengths are layered, which allows for expansion of the sensitivity wavelength region of the photoelectric conversion element.

In the example illustrated in Fig. 3, among all combinations of two adjacent quantum dot layers, the band gap energy of the quantum dot layer closer to the first electrode 2 is smaller than the band gap energy closer to the second electrode 3 in three combinations, excluding the one combination of the second quantum dot layer 4b and the third quantum dot layer 4c.

Also, in the present embodiment, the n quantum dot layers are layered such that there is no energy barrier in the direction in which electrons are transported at the interface between two adjacent quantum dot layers. As illustrated in Fig. 3, two adjacent quantum dot layers are layered to be in a relationship such that, for example, the energy difference $\Phi_3{}^e$ between the lower ends of the conduction bands, or in other words the electron conduction levels, in the third quantum dot layer 4c and the fourth quantum dot layer 4d does not create a barrier in the direction of electron transport at the interface between the third quantum dot layer 4c and the fourth quantum dot layer 4d. By layering the n quantum dot layers such that this relationship holds at the interface between two adjacent quantum dot layers for all of the n quantum dot layers, electrons out of the electron-hole pairs generated by photoelectric conversion can be suppressed from accumulating at the interface between specific quantum dot layers. By adopting a layered structure with no energy barrier in the electron transport direction as in Fig. 3, electrons accumulated at the interface between quantum dot layers can be suppressed from recombining with holes, and the sensitivity of the photoelectric conversion element 10A and photoelectric conversion element 10B can be improved.

The energy difference between the lower ends of the conduction bands at the interface between two adjacent quantum dot layers can be measured using inverse photoelectron spectroscopy, for example. Specifically, after measuring the energy at the lower end of the conduction band of one of two adjacent quantum dot layers, the energy at the lower end of the conduction band of the other quantum dot layer is obtained by measuring the other quantum dot layer while adding the next layer, and the energy difference between the two can simply be calculated. Consequently, in the layered structure of the n quantum dot layers in the present embodiment, the energy difference $\Phi_i{}^e$ between the lower ends of the conduction bands at the interface between each of the n quantum dot layers and an adjacent quantum dot layer satisfies Expression (7) below.

$$\Phi_i{}^e = E_{i+1}{}^{CBM} - E_i{}^{CBM} \geq 0 \ (\text{where } 1 \leq i < n) \quad (7)$$

Here, $E_i{}^{CBM}$ and $E_{i+1}{}^{CBM}$ are the energies of the lower ends of the conduction bands of the i-th and the (i+1)-th quantum dot layers, respectively, of the n quantum dot layers, counting from the first electrode 2. Also, i is an integer equal to or greater than 1 and less than n. Note that in Expression (7), 0 does not mean 0 in the strict sense. In practice, error of approximately 0.1 eV is produced depending on the precision of the measuring apparatus, and therefore $\Phi_i{}^e = -0.1$ may be considered to substantially satisfy Expression (7). Note that Expression (7) may also be $\Phi_i{}^e = E_{i+1}{}^{CBM} - E_i{}^{CBM} > 0$. Moreover, each expression indicating an energy relationship such as Expression (7) in this specification is written such that the greater the difference from the vacuum level is, the more positive the value is.

In the case where the vacuum level is the same at each interface, Expression (7) can be converted to Expression (8) below.

$$\Phi_i{}^e = \chi_{i+1} - \chi_i \geq 0 \ (\text{where } 1 \leq i < n) \quad (8)$$

Here, $\chi_i$ and $\chi_{i+1}$ are the electron affinities of the i-th and the (i+1)-th quantum dot layers, respectively, of the n quantum dot layers, counting from the first electrode 2. The electron affinity may be measured directly by inverse photoelectron spectroscopy, or calculated by subtracting the value of the optical energy gap determined by the absorption end wavelength of the absorption spectrum from the value of the ionization potential measured by electron spectroscopy or photoelectron yield spectroscopy.

Also, as illustrated in Fig. 3, there is an energy barrier $\Delta E_g$ at the interface between two adjacent quantum dot layers, the presence of which can suppress dark current produced by the thermal transition of electrons from the upper end of the valence band of one of the two adjacent quantum dot layers to the lower end of the conduction band of the other. In other words, when focusing on a specific quantum dot layer, the energy of the lower end of the conduction band of a quantum dot layer adjacent to the specific quantum dot layer is lower than the energy of the upper end of the valence band of the specific quantum dot layer.

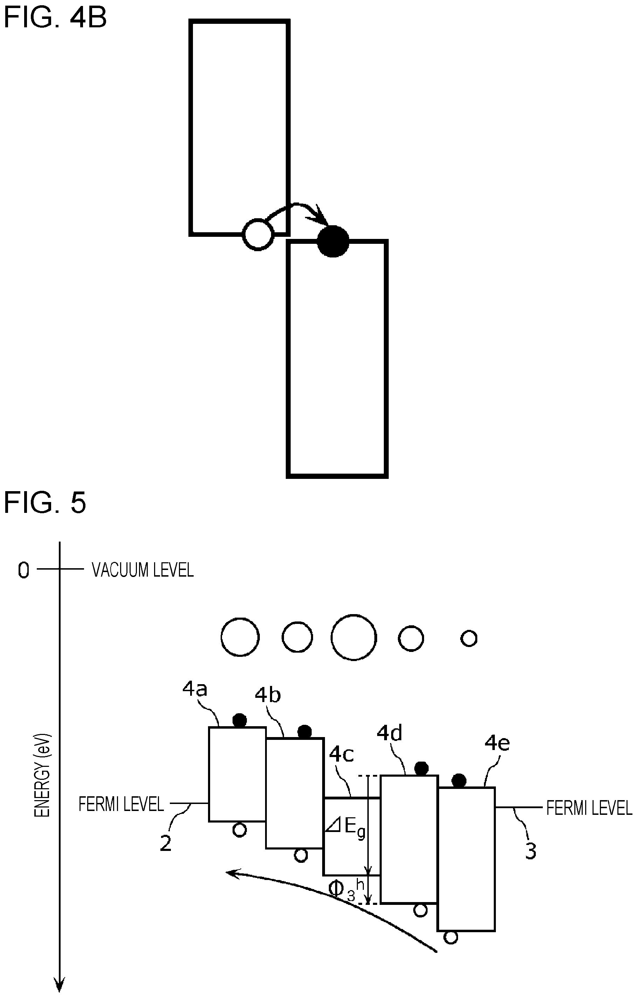

Figs. 4A and 4B are diagrams for explaining an energy barrier at the interface between two adjacent quantum dot layers. As illustrated in Fig. 4A, providing an energy barrier $\Delta E_{g,i}$ at the interface between two adjacent quantum dot layers allows for suppression of dark current produced by the thermal transition of electrons from the upper end of the valence band of one of the two adjacent quantum dot layers to the lower end of the conduction band of the other. When there is no energy barrier $\Delta E_{g,i}$ at the interface between two adjacent quantum dot layers, electron-hole pairs are easily generated even in the absence of light incidence, as illustrated in Fig. 4B, dark current is readily produced due to holes, which are signal charges, being transported to the first electrode 2, and noise in the imaging apparatus is readily increased, for example. The energy barrier $\Delta E_{g,i}$ is sufficiently large compared to the thermal energy at the temperature of use, for example. At finite temperatures, the thermal energy raises the probability of electrons transitioning beyond the energy barrier $\Delta E_{g,i}$ at the interface between two adjacent quantum dot layers. For example, in the state illustrated in Fig. 4B, electrons transition easily with thermal energy. These charges of thermal excitation become dark current, which readily increases noise in the imaging apparatus, for example. Accordingly, the energy barrier $\Delta E_{g,i}$ may be enlarged in the range within which the above-described energy different $\Phi_i^e$ satisfies Expression (7). For example, providing an energy barrier $\Delta E_{g,i}$ higher than the thermal energy can better suppress electron transitions.

Consequently, in the layered structure of the n quantum dot layers in the present embodiment, the energy barrier $\Delta E_{g,i}$ at the interface between each of the n quantum dot layers and an adjacent quantum dot layer satisfies Expression (9) below, for example.

$$\Delta E_{g,i} = E_i{}^{VBM} - E_{i+1}{}^{CBM} > 0 \text{ (where } 1 \leq i < n) \qquad (9)$$

Here, $E_i{}^{VBM}$ is the energy of the upper end of the valence band of the i-th quantum dot layer of the n quantum dot layers, counting from the first electrode 2.

In the case where the vacuum level is the same at each interface, Expression (9) can be converted to Expression (10) below.

$$\Delta E_{g,i} = I_i - \chi_{i+1} > 0 \text{ (where } 1 \leq i < n) \qquad (10)$$

Here, $I_i$ is the ionization potential of the i-th quantum dot layer of the n quantum dot layers, counting from the first electrode 2.

Also, as illustrated in Fig. 3, the energy of the upper end of the valence band of the n-th quantum dot layer (in the example illustrated in Fig. 3, the fifth quantum dot layer 4e) of the n quantum dot layers, counting from the first electrode 2, is equal to or higher than the energy of the upper end of the valence band of each of the 1st to the (n-1)-th quantum dot layers (in the example illustrated in Fig. 3, the first quantum dot layer 4a to the fourth quantum dot layer 4d) of the n quantum dot layers, counting from the first electrode 2, for example. The n-th quantum dot layer of the n quantum dot layers, counting from the first electrode 2, has the highest energy of the upper end of the valence band among the n quantum dot layers, for example. The n-th quantum dot layer above is the quantum dot layer closest to the second electrode 3 among the n quantum dot layers. By causing the energies of the upper ends of the valence bands of the n quantum dot layers to be in such a relationship, the movement of holes, which are signal charges, from the n-th quantum dot layer above to the second electrode 3 can be suppressed, and the sensitivity of the photoelectric conversion element can be improved.

To achieve n quantum dot layers having energy bands like those described above, such as by satisfying Expression (7) or (8) and Expression (9) or (10), at least one of the constituent element and the particle diameter of the quantum dots in each quantum dot layer is adjusted and the surfaces of the quantum dots in each quantum dot layer are modified by appropriate surface-modifying ligands, for example.

The surface-modifying ligands may be any ligands that would be adsorbed on the surfaces of quantum dots, and can be selected from the ligands described in NPL 2, for example. For example, the energy of the upper end of the valence band of quantum dots changes depending on the type of surface-modifying ligands. Accordingly, by appropriately setting at least one of the constituent element and the particle diameter of the quantum dots in each quantum dot layer and the type of surface-modifying ligands, quantum dot layers can be layered with the energy of the upper end of the valence band and the energy of the lower end of the conduction band set to desired values. For example, the surface-modifying ligands may be mutually different for at least two of the n quantum dot layers. The surface-modifying ligands may also be mutually different for all of the n quantum dot layers.

As another example, the densities of surface-modifying ligands modifying the surfaces of quantum dots may be mutually different for at least two of the n quantum dot layers. Specifically, the density of surface-modifying ligands is the number of surface-modifying ligands coordinated to a quantum dot surface per unit area. The higher the density of surface-modifying ligands, the greater the change is in the energy of the upper end of the valence band of the quantum dots, and therefore a quantum dot layer with the desired energy band can also be achieved by appropriately setting the density of surface-modifying ligands. Additionally, the densities of surface-modifying ligands on the surfaces of quantum dots may also be mutually different for all of the n quantum dot layers.

The surfaces of available quantum dots are often modified with surface-modifying ligands having long-chain alkyls to increase dispersion during synthesis. Surface-modifying ligands having long-chain alkyls hinders the movement of charges, and therefore are substituted with surface-modifying ligands for achieving a desired energy band. Known substitution methods include the solid-phase substitution method, in which quantum dots are formed into a solid-phase film and then exposed to a solution of the substituting surface-modifying ligands to induce substitution due to the concentration difference and the bond energy difference between the ligands, and the liquid-phase substitution method, in which the surface-modifying ligands are substituted in a liquid-phase solution. These existing methods can be used. These methods can be used to modify the surfaces of quantum dots with a desired type of surface-modifying ligands at a desired density.

[Electron blocking layer and hole blocking layer]

Referring to Figs. 2A and 2B again, the electron blocking layer 5 and the hole blocking layer 6 will be described.

In the present embodiment, of the hole-electron pairs produced in the photoelectric conversion layer 4, the holes are collected at the first electrode 2 while the electrons are collected at the second electrode 3. At this time, charges of opposite polarity to the charges collected by the first electrode 2 and the second electrode 3 may be injected into the photoelectric conversion layer 4 from the first electrode 2 and the second electrode 3. The charges injected from the electrodes in this way are a cause of dark current that flows irrespectively of the incidence of light on the photoelectric conversion layer 4.

For this reason, the photoelectric conversion element according to the present embodiment may include the electron blocking layer 5 as a charge blocking layer for dark current suppression between the first electrode 2 and the first quantum dot layer 4a, as in the photoelectric conversion element 10B illustrated in Fig. 2A. As illustrated in Fig. 2B, the electron blocking layer 5 acts as a barrier to electron injection from the first electrode 2. To suppress dark current due to electron injection from the first electrode 2, the electron affinity $\chi_{EBL}$ of the electron blocking layer 5 is equal to or less than the electron affinity $\chi_1$ of the first quantum dot layer 4a closest to the electron blocking layer 5 among the five quantum dot layers, for example. As another example, the ionization potential $I_{EBL}$ of the electron blocking layer 5 is equal to or less a value 0.5 eV greater than the ionization potential $I_1$ of the first quantum dot layer 4a as an upper limit, so as not to impede the conduction of holes from the first quantum dot layer 4a to the first electrode 2.

For example, the material of the electron blocking layer 5 is a material satisfying the above electron affinity and ionization potential relationships, and is a p-type semiconductor, for example. The material of the electron blocking layer 5 may be an organic material such as [N4,N4'-Di(naphthalen-1-yl)-N4,N4'-bis(4-vinylphenyl)biphenyl-4,4'-diamine] (VNPB) or poly[N,N'-bis(4-butylphenyl)-N,N'-bis(phenyl)-benzidine] (poly-TPD), or a metal oxide such as NiO, CoO, $Co_3O_4$, $Cr_2O_3$, $Cu_2O$, or CuO.

Similarly, the photoelectric conversion element according to the present embodiment may include the hole blocking layer 6 as a charge blocking layer between the second electrode 3 and the fifth quantum dot layer 4e, as in the photoelectric conversion element 10B illustrated in Fig. 2A. As illustrated in Fig. 2B, the hole blocking layer 6 acts as a barrier to hole injection from the second electrode 3. In this case, to suppress dark current due to hole injection from the second electrode 3, the ionization potential $I_{HBL}$ of the hole blocking layer 6 is equal to or higher than the ionization potential $I_5$ of the fifth quantum dot layer 4e closest to the hole blocking layer 6 among the five quantum dot layers, for example. As another example, the electron affinity $\chi_{HBL}$ of the hole blocking layer 6 is equal to or higher than the electron affinity $\chi_5$ of the fifth quantum dot layer 4e, so as not to impede the conduction of electrons from the fifth quantum dot layer 4e to the second electrode 3, for example.

For example, the material of the hole blocking layer 6 is a material satisfying the above electron affinity and ionization potential relationships, and is an n-type semiconductor, for example. Examples of the material of the hole blocking layer 6 include bathocuproine (BCP), bathophenanthroline (BPhen), fullerenes, zinc oxide, aluminumdoped zinc oxide, titanium oxide, and tin oxide.

The electron blocking layer 5 transports holes, and thus has hole conductivity. The hole blocking layer 6 transports electrons, and thus has electron conductivity. Accordingly, by causing the first quantum dot layer 4a to be in contact with the electron blocking layer 5, the first quantum dot layer 4a is electrically connected to the first electrode 2 through the electron blocking layer 5. Also, by causing the fifth quantum dot layer 4e to be in contact with the hole blocking layer 6, the fifth quantum dot layer 4e is electrically connected to the second electrode 3 through the hole blocking layer 6.

Note that the photoelectric conversion element 10B may also include only one of either the electron blocking layer 5 or the hole blocking layer 6.

(Embodiment 2)

Next, Embodiment 2 will be described. Embodiment 2 describes a photoelectric conversion element including a photoelectric conversion layer 4 having a layered structure of quantum dot layers with energy bands different from Embodiment 1 are layered. The photoelectric conversion element according to Embodiment 2 is the same as the photoelectric conversion element according to Embodiment 1 except for the energy bands of the n quantum dot layers included in the photoelectric conversion layer 4. In the following description of Embodiment 2, the differences from Embodiment 1 will be described primarily, while description of the commonalities will be omitted or simplified.

Fig. 5 is a diagram illustrating an example of an energy diagram for a photoelectric conversion layer according to the present embodiment. Fig. 5 illustrates an example of an energy diagram for the case in which five quantum dot layers are layered, the layers containing quantum dots of the same constituent element but mutually different particle diameters. Also, Fig. 5 schematically illustrates the particle size of the quantum dots contained in each quantum dot layer above the energy band of each quantum dot layer.

In the present embodiment, similarly to Embodiment 1, the band gap energy of the quantum dot layer closer to the first electrode 2 is lower than the band gap energy of the quantum dot layer closer to the second electrode 3 in at least one combination of two adjacent quantum dot layers among the n quantum dot layers. In the example illustrated in Fig. 5, among all combinations of two adjacent quantum dot layers, the band gap energy of the quantum dot layer closer to the first electrode 2 is smaller than the band gap energy closer to the second electrode 3 in three combinations, excluding the one combination of the second quantum dot layer 4b and the third quantum dot layer 4c.

Also, in the present embodiment, the n quantum dot layers are layered such that there is no energy barrier in the direction in which holes are transported at the interface between two adjacent quantum dot layers. As illustrated in Fig. 5, two adjacent quantum dot layers are layered to be in a relationship such that, for example, the energy difference $\Phi_3^h$ between the upper ends of the valence bands, or in other words the hole conduction levels, in the third quantum dot layer 4c and the fourth quantum dot layer 4d does not create a barrier in the direction of hole transport at the interface between the third quantum dot layer 4c and the fourth quantum dot layer 4d. By layering the n quantum dot layers such that this relationship holds at the interface between two adjacent quantum dot layers for all of the n quantum dot layers, holes out of the electron-hole pairs generated by photoelectric conversion can be suppressed from accumulating at the interface between specific quantum dot layers. By adopting a layered structure with no energy barrier in the hole transport direction as in Fig. 5, holes accumulated at the interface between quantum dot layers can be suppressed from recombining with electrons, and the sensitivity of the photoelectric conversion element 10A and photoelectric conversion element 10B can be improved. Also, charge transport of holes, which are signal charges generated by photoelectric conversion, stagnates less readily. Accordingly, for example, lowered response speed can be suppressed in cases such as when using the photoelectric conversion element in an imaging apparatus that treats holes as signal charges.

In the layered structure of the n quantum dot layers in the present embodiment, the energy difference $\Phi_i^h$ between the upper ends of the valence bands at the interface between each of the n quantum dot layers and an adjacent quantum dot layer satisfies Expression (11) below.

$$\Phi_i^h = E_{i+1}^{VBM} - E_i^{VBM} \geq 0 \text{ (where } 1 \leq i < n) \text{ (11)}$$

Here, $E_i^{VBM}$ and $E_{i+1}^{VBM}$ are the energies of the upper ends of the valence bands of the i-th and the (i+1)-th quantum dot layers, respectively, of the n quantum dot layers, counting from the first electrode 2. Note that Expression (11) may also be $\Phi_i^h = E_{i+1}^{VBM} - E_i^{VBM} > 0$.

Also, similarly to Embodiment 1, in the case where the vacuum level is the same at each interface, Expression (11) can be converted to Expression (12) below.

$$\Phi_i^h = I_{i+1} - I_i \geq 0 \text{ (where } 1 \leq i < n) \text{ (12)}$$

Here, $I_i$ and $I_{i+1}$ are the ionization potentials of the i-th and the (i+1)-th quantum dot layers, respectively, of the n quantum dot layers, counting from the first electrode 2.

Moreover, similarly to Embodiment 1, from the standpoint of suppressing dark current, the energy barrier $\Delta E_{g,i}$ at the interface between each of the n quantum dot layers and an adjacent quantum dot layer satisfies Expression (9) above, for example. Also, in the present embodiment, in the case where the vacuum level is the same at each interface, the above energy relationship satisfies Expression (10) above.

Also, as illustrated in Fig. 5, the energy of the lower end of the conduction band of the 1st quantum dot layer (in the example illustrated in Fig. 5, the first quantum dot layer 4a) of the n quantum dot layers, counting from the first electrode 2, is equal to or lower than the energy of the lower end of the conduction band of each of the 2nd to the n-th quantum dot layers (in the example illustrated in Fig. 5, the second quantum dot layer 4b to the fifth quantum dot layer 4e) of the n quantum dot layers, counting from the first electrode 2, for example. The 1st quantum dot layer of the n quantum dot layers, counting from the first electrode 2, has the lowest energy of the lower end of the conduction band among the n quantum dot layers, for example. The 1st quantum dot layer above is the quantum dot layer closest to the first electrode 2 among the n quantum dot layers. By causing the energies of the lower ends of the conduction bands of the n quantum dot layers to be in such a relationship, the movement of electrons, which are charges of opposite polarity to the signal charges, from the 1st quantum dot layer above to the first electrode 2 can be suppressed, and the sensitivity of the photoelectric conversion element can be improved.

(Embodiment 3)

Next, Embodiment 3 will be described. Embodiment 3 describes a photoelectric conversion element including a photoelectric conversion layer 4 having a layered structure of quantum dot layers with energy bands different from Embodiments 1 and 2 are layered. The photoelectric conversion element according to Embodiment 3 is the same as the photoelectric conversion element according to Embodiment 1 except for the energy bands of the n quantum dot layers included in the photoelectric conversion layer 4. In the following description of Embodiment 3, the differences from Embodiments 1 and 2 will be described primarily, while description of the commonalities will be omitted or simplified.

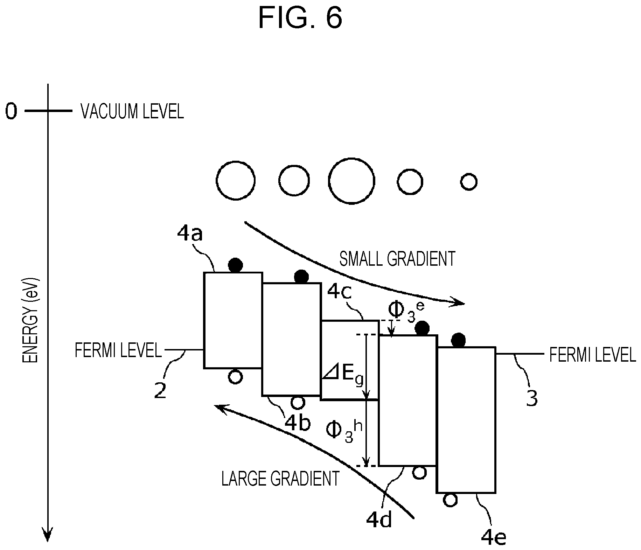

Fig. 6 is a diagram illustrating an example of an energy diagram for a photoelectric conversion layer according to the present embodiment. Fig. 6 illustrates an example of an energy diagram for the case in which five quantum dot layers are layered, the layers containing quantum dots of the same constituent element but mutually different particle diameters. Also, Fig. 6 schematically illustrates the particle size of the quantum dots contained in each quantum dot layer above the energy band of each quantum dot layer.

In the present embodiment, similarly to Embodiment 1, the band gap energy of the quantum dot layer closer to the first electrode 2 is lower than the band gap energy of the quantum dot layer closer to the second electrode 3 in at least one combination of two adjacent quantum dot layers among the n quantum dot layers. In the example illustrated in Fig. 6, among all combinations of two adjacent quantum dot layers, the band gap energy of the quantum dot layer closer to the first electrode 2 is smaller than the band gap energy closer to the second electrode 3 in three combinations, excluding the one combination of the second quantum dot layer 4b and the third quantum dot layer 4c.

Also, in the present embodiment, the n quantum dot layers are layered such that there is no energy barrier in each of the direction in which electrons are transported and the direction in which holes are transported at the interface between two adjacent quantum dot layers. By layering the n quantum dot layers such that this relationship holds at the interface between two adjacent quantum dot layers for all of the n quantum dot layers, electrons and holes generated by photoelectric conversion can both be suppressed from accumulating at the interface between specific quantum dot layers. Consequently, the sensitivity and the response speed of the photoelectric conversion element can be improved.

In the layered structure of the n quantum dot layers in the present embodiment, the energy relationship at the interface between each of the n quantum dot layers and an adjacent quantum dot layer satisfies Expressions (7), (9), and (11). Also, in the present embodiment, in the case where the vacuum level is the same at each interface, the above energy relationship satisfies Expressions (8), (10), and (12).

Also, as illustrated in Fig. 6, in the n quantum dot layers, the potential gradient for holes, which are signal charges, in the direction proceeding to the first electrode 2 is greater than the potential gradient for electrons, which are charges of opposite polarity to the signal charges, in the direction proceeding to the second electrode 3. This speeds up the collection of signal charges, enabling the realization of a photoelectric conversion element with enhanced responsiveness to signal charges. By enhancing the responsiveness of the photoelectric conversion element to signal charges, the frame rate can be increased in an imaging apparatus using the photoelectric conversion element, for example. Note that the potential gradient for holes and the potential gradient for electrons may also be equal.

In this specification, the potential gradient for holes corresponds to, for example, the difference between the energy of the upper end of the valence band of the n-th quantum dot layer of the n quantum dot layers, counting from the first electrode 2, and the energy of the upper end of the valence band of the 1st quantum dot layer, counting from the first electrode 2. The potential gradient for electrons corresponds to, for example, the difference between the energy of the lower end of the conduction band of the n-th quantum dot layer of the n quantum dot layers, counting from the first electrode 2, and the energy of the lower end of the conduction band of the 1st quantum dot layer, counting from the first electrode 2.

(Embodiment 4)

Next, Embodiment 4 will be described. Embodiment 4 describes a photoelectric conversion element including a photoelectric conversion layer 4 having a layered structure of quantum dot layers with energy bands different from Embodiments 1 to 3 are layered. The photoelectric conversion element according to Embodiment 4 is the same as the photoelectric conversion element according to Embodiment 1 except for the energy bands of the n quantum dot layers included in the photoelectric conversion layer 4. In the following description of Embodiment 4, the differences from Embodiments 1 to 3 will be described primarily, while description of the commonalities will be omitted or simplified.

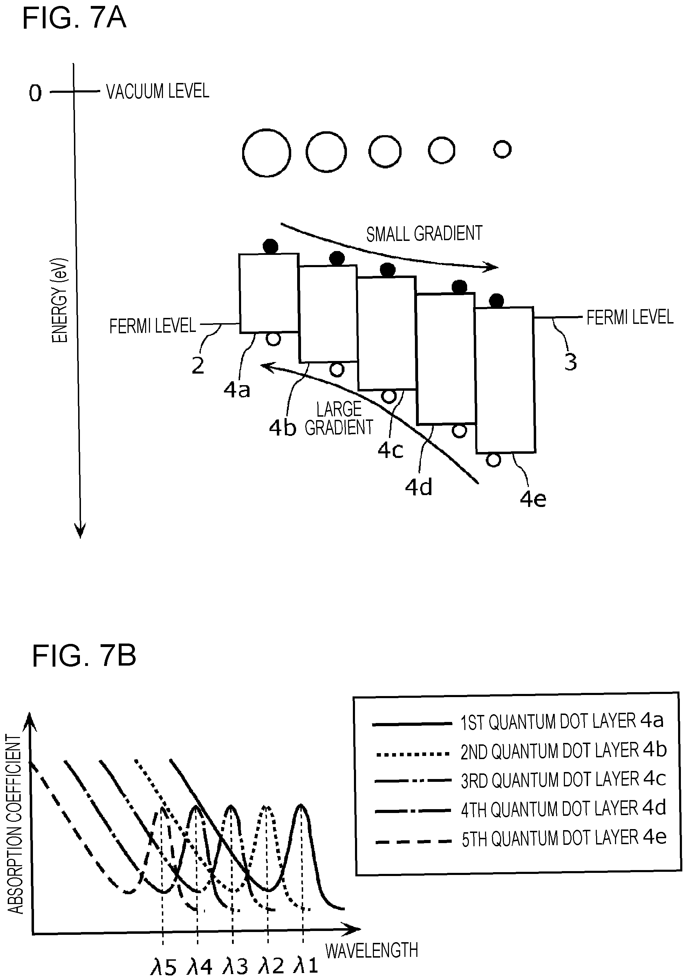

Fig. 7A is a diagram illustrating an example of an energy diagram for a photoelectric conversion layer according to the present embodiment. Fig. 7A illustrates an example of an energy diagram for the case in which five quantum dot layers are layered, the layers containing quantum dots of the same constituent element but mutually different particle diameters. Also, Fig. 7A schematically illustrates the particle size of the quantum dots contained in each quantum dot layer above the energy band of each quantum dot layer.

In Embodiments 1 to 3, the magnitudes of the particle diameters of the quantum dots do not change monotonically with the layering order of the n quantum dot layers. In contrast, in the present embodiment, the particle diameters of the quantum dots contained in each of the n quantum dot layers decrease in order from the quantum dot layer close to the first electrode 2.

Also, in the example illustrated in Fig. 7A, the quantum dots contained in each of the quantum dot layers are quantum dots of the same constituent element, and therefore as the particle diameter changes, the band gap energy of each of the n quantum dot layers increases in order from the quantum dot layer close to the first electrode 2. Accordingly, the band gap energy of the quantum dot layer closer to the first electrode 2 is lower than the band gap energy of the quantum dot layer closer to the second electrode 3 in all combinations of two adjacent quantum dot layers among the n quantum dot layers.

Also, in the present embodiment, the n quantum dot layers are layered such that there is no energy barrier in each of the direction in which electrons are transported and the direction in which holes are transported at the interface between two adjacent quantum dot layers. By layering the n quantum dot layers such that this relationship holds at the interface between two adjacent quantum dot layers for all of the n quantum dot layers, electrons and holes generated by photoelectric conversion can both be suppressed from accumulating at the interface between specific quantum dot layers. Consequently, the sensitivity and the response speed can be improved. Accordingly, in the layered structure of the n quantum dot layers in the present embodiment, the energy relationship at the interface between each of the n quantum dot layers and an adjacent quantum dot layer satisfies both Expression (7) and Expression (11). Also, to suppress dark current, in the present embodiment, the above energy relationship satisfies Expression (9). Also, in the present embodiment, in the case where the vacuum level is the same at each interface, the above energy relationship satisfies Expressions (8), (10), and (12).

Fig. 7B is a diagram schematically illustrating an example of the absorption spectra of quantum dot layers. As illustrated in Fig. 7B, the quantum dot layers, which contain quantum dots with mutually different particle diameters, each have an absorption peak near the absorption end and have an absorption wavelength region in which the absorption coefficient increases with shorter wavelengths on the short wavelength side from the absorption peak. Note that in this specification, when the absorption peak of a quantum dot or a quantum dot layer is simply referred to as an "absorption peak", this means the absorption peak farthest on the long wavelength side near the absorption end, unless specifically noted otherwise. This absorption peak is also referred to as the "first excitation peak" of a quantum dot.

Also, since each quantum dot layer has a band gap energy as described above, the absorption peak wavelength of each of the n quantum dot layers decreases in order from the quantum dot layer close to the first electrode 2. In the example illustrated in Fig. 7B, the absorption peak wavelengths of the first quantum dot layer 4a to the fifth quantum dot layer 4e are $\lambda 1$ to $\lambda 5$, respectively, and the wavelengths decrease in order from $\lambda 1$ to $\lambda 5$.

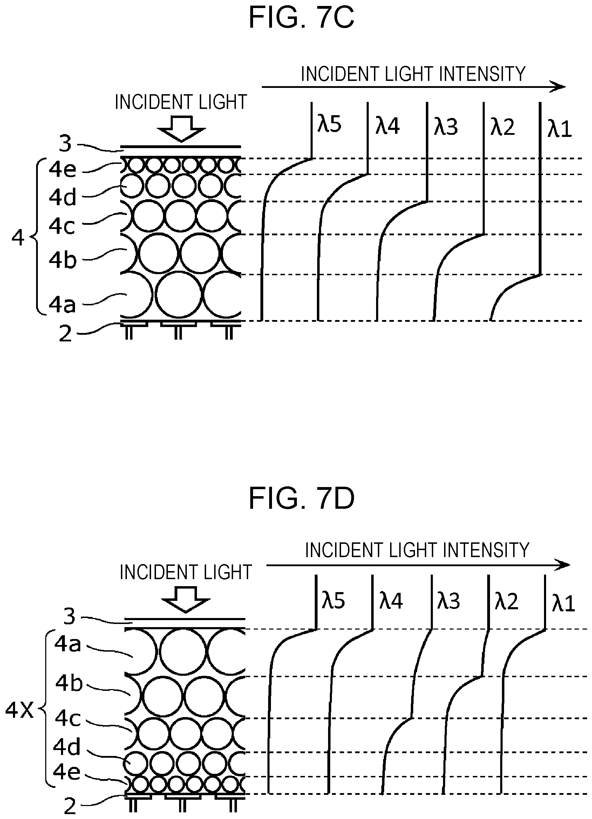

Fig. 7C is a diagram for explaining the absorption of light, including the absorption peak wavelength of each quantum dot layer, within the photoelectric conversion layer 4 according to the present embodiment. Fig. 7D is a diagram for explaining the absorption of light, including the absorption peak wavelength of each quantum dot layer, within a photoelectric conversion layer 4X in which the layering order of quantum dot layers is altered from the photoelectric conversion layer 4 according to the present embodiment. The graphs on the right side of Figs. 7C and 7D schematically illustrate the change in the intensity of light of each of the wavelengths $\lambda 1$ to $\lambda 5$ for light containing the wavelengths $\lambda 1$ to $\lambda 5$ incident on the photoelectric conversion layer 4 from the second electrode 3 side. The vertical direction in the graphs on the right side of Figs. 7C and 7D indicates the position in the layering direction of the layered quantum dot layers. Note that in the graphs on the right side of Figs. 7C and 7D, the respective intensities of light of the wavelengths $\lambda 1$ to $\lambda 5$ are illustrated with mutually different offsets applied.

As illustrated in Fig. 7B, the absorption wavelength region on the short wavelength side of the absorption peak wavelength of a certain quantum dot layer overlaps with the absorption peak wavelength of a different quantum dot layer with a shorter absorption peak wavelength. For example, the absorption wavelength region on the short wavelength side from λ1 of the first quantum dot layer 4a, λ1 being the longest absorption peak wavelength, overlaps with the absorption peak wavelengths λ2 to λ5 of the second quantum dot layer 4b to the fifth quantum dot layer 4e. That is, light of the absorption peak wavelength of a quantum dot layer having an absorption peak of relatively short wavelength is absorbed in a quantum dot layer having an absorption peak of relatively long wavelength. As illustrated in Fig. 7C, by layering the quantum dot layers such that the particle diameter decreases in order from the quantum dot layer close to the first electrode 2, the absorption peak wavelengths of the quantum dot layers increase in the order of λ5 to λ1 from the side where light is incident. Accordingly, when light containing the wavelengths λ1 to λ5 is incident from the second electrode 3 side, light of the absorption peak wavelength of each quantum dot layer reaches and is absorbed by each quantum dot layer at the incident light intensity, with little or no absorption by the other quantum dot layers. As a result, electron-hole pairs are readily produced evenly throughout the entire photoelectric conversion layer 4.

On the other hand, in the photoelectric conversion layer 4X illustrated in Fig. 7D, the first quantum dot layer 4a to the fifth quantum dot layer 4e are layered in the reverse order of the photoelectric conversion layer 4. As illustrated in Fig. 7D, if the quantum dot layers are layered such that the particle diameter increases in order from the quantum dot layer close to the first electrode 2, the absorption peak wavelengths of the quantum dot layers decrease in the order of λ1 to λ5 from the side where light is incident. Accordingly, when light containing the wavelengths λ1 to λ5 is incident from the second electrode 3 side, light of the absorption peak wavelength of each quantum dot layer is absorbed by the first quantum dot layer 4a with the largest particle diameter, or in other words, by the first quantum dot layer 4a with the longest absorption peak wavelength. This is because the first quantum dot layer 4a with the longest absorption peak wavelength exhibits high light absorption with respect to light of λ2 to λ5, that is, wavelengths shorter than the absorption peak wavelength λ1. In the example illustrated in Fig. 7D, the first quantum dot layer 4a absorbs almost all light of wavelengths λ4 and λ5 out of the incident light. Even if there is light transmitted through the first quantum dot layer 4a, the closer a quantum dot layer is to the second electrode 3, the longer the absorption peak wavelength is and the wider the range of absorbed wavelengths is, and therefore the closer a quantum dot layer is to the first electrode 2, the more that the intensity of the incident light weakens and the amount of absorbed light decreases. In such a case, electron-hole pairs generated by light incidence become concentrated in the quantum dot layers in the vicinity of the second electrode 3, and the high concentration of carriers produced causes the electrons and holes to recombine and become inactivated, reducing the sensitivity of the photoelectric conversion element. In particular, the holes produced in the quantum dot layers in the vicinity of the second electrode 3 are far from the first electrode 2 that collects holes, and thus are readily inactivated before being collected by the first electrode 2 as signal charges. Therefore, the holes, which are signal charges, are not collected efficiently.

Consequently, by layering the quantum dot layers such that the particle diameter decreases in order from the quantum dot layer close to the first electrode 2, as in the photoelectric conversion layer 4 according to the present embodiment, photoelectric conversion readily occurs in the vicinity of the first electrode 2. In particular, when light is incident from the second electrode 3 side, the incident light can be utilized effectively. Therefore, the sensitivity of the photoelectric conversion element can be improved. Also, since the n quantum dot layers have mutually different band gap energies (that is, absorption peak wavelengths), the sensitivity wavelength region of the photoelectric conversion element can be expanded. Note that by also configuring the photoelectric conversion elements according to Embodiments 1 to 3 such that the band gap energy of the quantum dot layer closer to the first electrode 2 is lower than the band gap energy of the quantum dot layer closer to the second electrode 3 in at least one combination of two adjacent quantum dot layers among the n quantum dot layers, photoelectric conversion can occur more readily even in the quantum dot layer close to the first electrode 2, and the sensitivity of the photoelectric conversion element can be improved, for the reasons given above.

Also, the quantum dots with the smallest particle diameter have the highest band gap energy. Accordingly, as illustrated in Fig. 7A, in the case of adopting a layered structure in which the particle diameter is smallest for the quantum dots contained in the fifth quantum dot layer 4e closest to the second electrode 3, the energy difference is greatest between the Fermi level of the second electrode 3 and the energy of the upper end of the valence band of the fifth quantum dot layer 4e. Therefore, it is possible so suppress dark current collected at the first electrode 2 due to the injection of holes into the photoelectric conversion layer 4 from the second electrode 3 when a voltage is applied such that the second electrode 3 has a positive potential with respect to the first electrode 2 to make holes the signal charges.

Also, by setting the layering order of the n quantum dot layers according to the present embodiment, the band gap energy is lower the closer a quantum dot layer is to the first electrode 2. Accordingly, if the quantum dot layers are configured such that the energy of the lower end of the conduction band is lower the closer a quantum dot layer is to the first electrode 2 in order to satisfy Expression (7) above, the energy of the upper end of the valence band of each quantum dot layer changes so as to decrease in the direction proceeding to the first electrode 2, with a larger step width compared to the change in the energy of the lower end of the conduction band. That is, in the n quantum dot layers, the potential gradient for holes, which are signal charges, in the direction proceeding to the first electrode 2 is greater than the potential gradient for electrons, which are charges of opposite polarity to the signal charges, in the direction proceeding to the second electrode 3. Moreover, the difference between the potential gradient for holes and the potential gradient for electrons also easily becomes large. This further speeds up the collection of signal charges, enabling the realization of a photoelectric conversion element with further enhanced responsiveness to signal charges.

As above, in the photoelectric conversion element according to Embodiments 1 to 4, at least one of Expression (7) and Expression (11) is satisfied by the n quantum dot layers. With this arrangement, the n quantum dot layers are layered so as not to create an energy barrier to the transport of at least one of holes and electrons. Accordingly, the accumulation of charges generated by photoelectric conversion at the interface between specific quantum dot layers can be suppressed. Therefore, the sensitivity of the photoelectric conversion element can be improved.

Also, in the photoelectric conversion element according to Embodiments 1 to 4, the band gap energy of the quantum dot layer closer to the first electrode 2 is lower than the band gap energy of the quantum dot layer closer to the second electrode 3 in at least one combination of two adjacent quantum dot layers among the n quantum dot layers. With this arrangement, out of two adjacent quantum dot layers, light of the absorption peak wavelength of the quantum dot layer closer to the first electrode 2 is absorbed less readily by the quantum dot layer closer to the second electrode 3. As a result, photoelectric conversion occurs more readily in the quantum dot layer closer to the first electrode 2, and the first electrode 2 collects the signal charges more readily. Therefore, the sensitivity of the photoelectric conversion element can be improved. Moreover, since the n quantum dot layers will include a combination of two adjacent quantum dot layers with different band gap energies, quantum dot layers with different absorption peak wavelengths are layered. Accordingly, the sensitivity wavelength region of the photoelectric conversion element can be expanded.

According to the above, in the photoelectric conversion element according to Embodiments 1 to 4, both an expansion of the sensitivity wavelength region and an improvement in sensitivity can be achieved.

(Embodiment 5)

Next, Embodiment 5 will be described. Embodiments 1 to 4 describe the case of treating holes as the signal charges, but Embodiment 5 describes the case of treating electrons as the signal charges. The case of treating electrons as the signal charges can be achieved by changing the energy band of each layer in the photoelectric conversion element according to Embodiments 1 to 4. The photoelectric conversion element according to Embodiment 5 is the same as the photoelectric conversion element according to Embodiment 1 except for the energy bands of the n quantum dot layers included in the photoelectric conversion layer 4, and the swapping of the positions of the electron blocking layer 5 and the hole blocking layer 6. In the following description of Embodiment 5, the differences from Embodiments 1 to 4 will be described primarily, while description of the commonalities will be omitted or simplified.

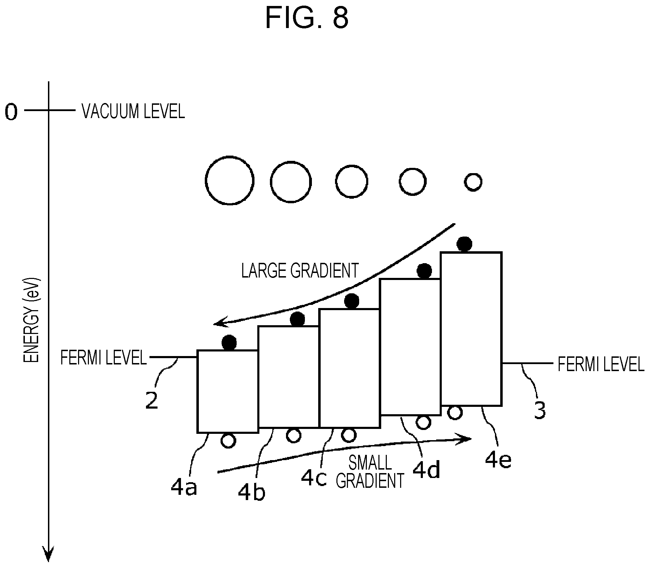

Fig. 8 is a diagram illustrating an example of an energy diagram for a photoelectric conversion layer according to the present embodiment. Fig. 8 illustrates an example of an energy diagram for the case in which five quantum dot layers are layered, the layers containing quantum dots of the same constituent element but mutually different particle diameters. Also, Fig. 8 schematically illustrates the particle size of the quantum dots contained in each quantum dot layer above the energy band of each quantum dot layer.

In the present embodiment, the first electrode 2 is an electron-collecting electrode that collects electrons produced in the photoelectric conversion layer 4 as the signal charges. Meanwhile, the second electrode 3 is a hole-collecting electrode that collects holes as the charges of the polarity of the signal charges produced in the photoelectric conversion layer 4.

The polarity of the bias voltage applied to the first electrode 2 and the second electrode 3 is determined such that, out of electron-hole pairs produced in the photoelectric conversion layer 4, the holes move to the second electrode 3 while the electrons move to the first electrode 2. Specifically, a bias voltage is applied such that the potential of the second electrode 3 is negative with respect to the first electrode 2. With this arrangement, the first electrode 2 collects electrons, that is, signal charges, while the second electrode 3 collects holes, that is, charges of opposite polarity to the signal charges, and flushes the collected holes to the outside, for example. Also, by making the work function of the second electrode 3 larger than the work function of the first electrode 2, the first electrode 2 may collect electrons and the second electrode 3 may flush holes under conditions in which there is no potential difference between the first and second electrodes.

As illustrated in Fig. 8, in the present embodiment, the n quantum dot layers are layered such that there is no energy barrier in each of the direction in which electrons are transported and the direction in which holes are transported at the interface between two adjacent quantum dot layers. By layering the n quantum dot layers such that this relationship holds at the interface between two adjacent quantum dot layers for all of the n quantum dot layers, electrons and holes generated by photoelectric conversion can both be suppressed from accumulating at the interface between specific quantum dot layers. Consequently, the sensitivity and the response speed can be improved. Specifically, in the layered structure of the n quantum dot layers in the present embodiment, the energy relationship at the interface between each of the n quantum dot layers and an adjacent quantum dot layer satisfies both Expression (13) and Expression (14) below.

$$\Phi_i^e = E_i^{CBM} - E_{i+1}^{CBM} \geq 0 \ (\text{where } 1 \leq i < n) \ (13)$$

$$\Phi_i^h = E_i^{VBM} - E_{i+1}^{VBM} \geq 0 \text{ (where } 1 \leq i < n) \quad (14)$$

Note that in the present embodiment, the above energy relationship may also satisfy one of either Expression (13) or Expression (14). Expression (13) may also be $\Phi_i^e = E_i^{CBM} - E_{i+1}^{CBM} > 0$. Expression (14) may also be $\Phi_i^h = E_i^{VBM} - E_{i+1}^{VBM} > 0$.

In the case where the vacuum level is the same at each interface, Expressions (13) and (14) can be converted to Expressions (15) and (16), respectively.

$$\Phi_i^e = \chi_i - \chi_{i+1} \geq 0 \text{ (where } 1 \leq i < n) \quad (15)$$

$$\Phi_i^h = I_i - I_{i+1} \geq 0 \text{ (where } 1 \leq i < n) \quad (16)$$

Also, in the present embodiment, dark current can be suppressed by providing an energy barrier $\Delta E_{g,i}$ at the interface between two adjacent quantum dot layers. Consequently, in the layered structure of the n quantum dot layers, the energy barrier $\Delta E_{g,i}$ at the interface between each of the n quantum dot layers and an adjacent quantum dot layer satisfies Expression (17) below, for example.

$$\Delta E_{g,i} = E_{i+1}^{VBM} - E_i^{CBM} > 0 \text{ (where } 1 \leq i < n) \quad (17)$$

In the case where the vacuum level is the same at each interface, Expression (17) can be converted to Expression (18).

$$\Delta E_{g,i} = I_{i+1} - \chi_i > 0 \text{ (where } 1 \leq i < n) \quad (18)$$

Also, as illustrated in Fig. 8, in the present embodiment, similarly to Embodiment 4, the particle diameters of the quantum dots contained in each of the n quantum dot layers decrease in order from the quantum dot layer close to the first electrode 2. Also, in the example illustrated in Fig. 8, the quantum dots contained in each of the quantum dot layers are quantum dots of the same constituent element, and therefore as the particle diameter changes, the band gap energy of each of the n quantum dot layers increases in order from the quantum dot layer close to the first electrode 2. Accordingly, the band gap energy of the quantum dot layer closer to the first electrode 2 is lower than the band gap energy of the quantum dot layer closer to the second electrode 3 in all combinations of two adjacent quantum dot layers among the n quantum dot layers. With this arrangement, similarly to Embodiment 4, electron-hole pairs are readily produced evenly throughout the entire photoelectric conversion layer 4, and the sensitivity of the photoelectric conversion element can be improved. Note that the band gap energy of the quantum dot layer closer to the first electrode 2 may also be equal to or greater than the band gap energy of the quantum dot layer closer to the second electrode 3 in some combinations of two adjacent quantum dot layers among the n quantum dot layers.

Also, since each quantum dot layer has a band gap energy as described above, the absorption peak wavelength of each of the n quantum dot layers decreases in order from the quantum dot layer close to the first electrode 2.

Also, by setting the layering order of the n quantum dot layers according to the present embodiment, the band gap energy is lower the closer a quantum dot layer is to the first electrode 2. Accordingly, if the quantum dot layers are configured such that the energy of the upper end of the valence band is lower the closer a quantum dot layer is to the first electrode 2 in order to satisfy Expression (13)above, the energy of the lower end of the conduction band of each quantum dot layer changes so as to increase in the direction proceeding to the second electrode 3, with a larger step width compared to the change in the energy of the upper end of the valence band. That is, in the n quantum dot layers, the potential gradient for electrons, which are signal charges, in the direction proceeding to the first electrode 2 is greater than the potential gradient for holes, which are charges of opposite polarity to the signal charges, in the direction proceeding to the second electrode 3. Moreover, the difference between the potential gradient for electrons and the potential gradient for holes also easily becomes large. This further speeds up the collection of signal charges, enabling the realization of a photoelectric conversion element with further enhanced responsiveness to signal charges.

Also, in the case where the photoelectric conversion element according to the present embodiment includes the electron blocking layer 5 and the hole blocking layer 6, the photoelectric conversion element including the electron blocking layer 5 and the hole blocking layer 6 can be achieved by adopting a configuration in which the positions of the electron blocking layer 5 and the hole blocking layer 6 are swapped as compared to the configuration of the photoelectric conversion element 10B illustrated in Fig. 2A. In other words, the photoelectric conversion element including the electron blocking layer 5 and the hole blocking layer 6 can be achieved by disposing the hole blocking layer 6 between the first electrode 2 and the photoelectric conversion layer 4 and disposing the electron blocking layer 5 between the second electrode 3 and the photoelectric conversion layer 4.

To suppress dark current due to electron injection from the second electrode 3, the electron affinity $\chi_{EBL}$ of the electron blocking layer 5 is equal to or less than the electron affinity $\chi_5$ of the fifth quantum dot layer 4e closest to the electron blocking layer 5 among the five quantum dot layers, for example. As another example, the ionization potential $I_{EBL}$ of the electron blocking layer 5 is equal to or less a value 0.5 eV greater than the ionization potential $I_5$ of the fifth quantum dot layer 4e as an upper limit, so as not to impede the conduction of holes from the fifth quantum dot layer 4e to the second electrode 3.

To suppress dark current due to hole injection from the first electrode 2, the ionization potential $I_{HBL}$ of the hole blocking layer 6 is equal to or higher than the ionization potential $I_1$ of the first quantum dot layer 4a closest to the hole blocking layer 6 among the five quantum dot layers, for example. As another example, the electron affinity $\chi_{HBL}$ of the hole blocking layer 6 is equal to or higher than the electron affinity $\chi_1$ of the first quantum dot layer 4a, so as not to impede the conduction of electrons from the first quantum dot layer 4a to the first electrode 2, for example.

As above, even in the case of collecting electrons as signal charges like in the photoelectric conversion element according to the present embodiment, both an expansion of the sensitivity wavelength region and an improvement in sensitivity can be achieved in a manner similar to the photoelectric conversion element according to Embodiments 1 to 4.

(Embodiment 6)

Next, Embodiment 6 will be described. Embodiment 6 describes an imaging apparatus using the photoelectric conversion element according to Embodiments 1 to 5. In the following description of Embodiment 6, the differences from Embodiments 1 to 5 will be described primarily, while description of the commonalities will be omitted or simplified.

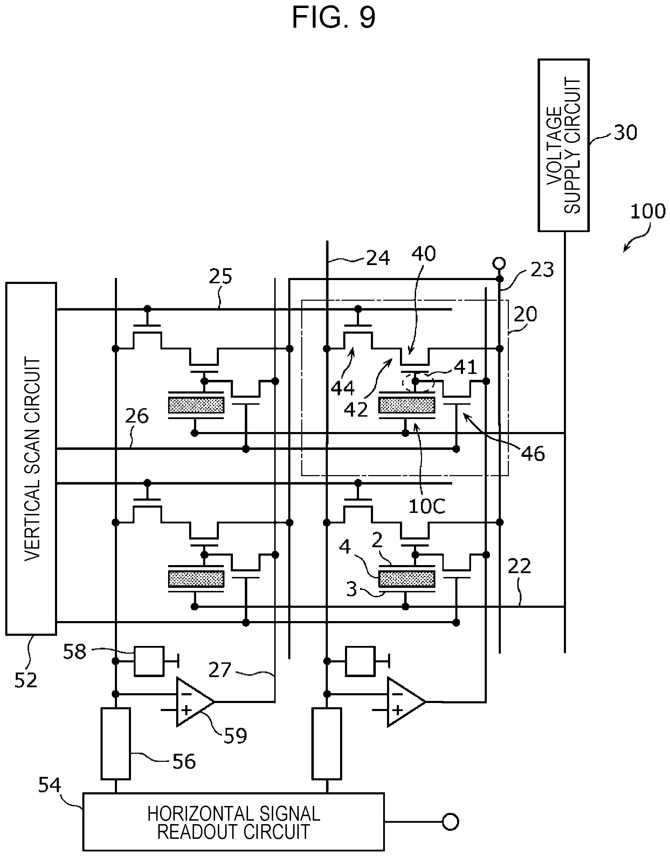

First, the overall configuration of an imaging apparatus according to the present embodiment will be described. Fig. 9 is a diagram illustrating an example of the circuit configuration of an imaging apparatus 100 according to the present embodiment. The imaging apparatus 100 illustrated in Fig. 9 has pixels 20 and peripheral circuits. The peripheral circuits include a voltage supply circuit 30 that supplies a predetermined voltage to each of the pixels 20.

The pixels 20 are arranged one-dimensionally or two-dimensionally on a semiconductor substrate to form a light-sensitive area, or in other words, a pixel area. In the configuration illustrated as an example in Fig. 9, the pixels 20 are arrayed in a row direction and a column direction. In this specification, the row direction and the column direction mean the directions in which rows and columns extend, respectively. That is, in the plane of the page of Fig. 9, the vertical direction is the column direction and the horizontal direction is the row direction. Fig. 9 illustrates four pixels 20 arranged in a $2\times2$ matrix. The number of pixels 20 illustrated in Fig. 9 is merely an illustrative example for the purpose of explanation, and the number of pixels 20 is not limited to four. In the case where the pixels 20 are arranged one-dimensionally, the imaging apparatus 100 is a line sensor.

The pixels 20 each has a photoelectric converter 10C and a signal detection circuit 40 that detects a signal generated by the photoelectric converter 10C. The signal detection circuit 40 is an example of a signal readout circuit. The photoelectric converter 10C includes the first electrode 2 and the second electrode 3, and the photoelectric conversion layer 4 disposed therebetween. The photoelectric converter 10C is configured as the photoelectric conversion element according to any of Embodiments 1 to 5, for example. Note that the following primarily describes an example in which the photoelectric converter 10C is configured as a photoelectric conversion element in which the first electrode 2 collects holes as signal charges, as in the photoelectric conversion element according to any of Embodiments 1 to 4. Note that the photoelectric converter 10C may also be configured as a photoelectric conversion element in which the first electrode 2 collects electrons as signal charges, as in the photoelectric conversion element according to Embodiment 5. The photoelectric converter 10C may also include the electron blocking layer 5 and the hole blocking layer 6 as in the photoelectric conversion element 10B described above.

The first electrode 2 functions as a charge collector. The signal detection circuit 40 is connected to the first electrode 2. The second electrode 3 is connected to the voltage supply circuit 30 via a storage control line 22. During operation of the imaging apparatus 100, a predetermined bias voltage is applied to the second electrode 3 via the storage control line 22. In the present embodiment, the first electrode 2 is a pixel electrode that collects signal charges, and the second electrode 3 is a counter electrode that faces the pixel electrode.

The photoelectric converter 10C is configured such that, out of electron-hole pairs produced by photoelectric conversion, the holes serving as signal charges (in other words, positive charges) are collected at the first electrode 2. Holes can be collected by the first electrode 2 by controlling the potential of the second electrode 3 using the bias voltage generated by the voltage supply circuit 30. The voltage supply circuit 30 supplies a voltage to the second electrode 3 via the storage control line 22 such that the second electrode 3 has a positive potential relative to the first electrode 2. Specifically, a voltage of approximately 10 V, for example, is applied to the storage control line 22 so that the potential of the second electrode 3 is higher than that of the first electrode 2. Note that in the case where the first electrode 2 collects electrons, the voltage supply circuit 30 supplies a voltage to the second electrode 3 via the storage control line 22 such that the second electrode 3 has a negative potential relative to the first electrode 2.

In the configuration illustrated as an example in Fig. 9, the signal detection circuit 40 includes an amplifying transistor 42, an address transistor 44, and a reset transistor 46. The amplifying transistor 42 is also referred to as a transistor for charge detection, and the address transistor 44 is also referred to as a row select transistor. Typically, the amplifying transistor 42 and the address transistor 44 are field-effect transistors (FETs) formed on a semiconductor substrate. The following describes an example of using n-channel metaloxide-semiconductor field-effect transistors (MOSFETs) as the transistors, unless specifically noted otherwise. The amplifying transistor 42, the address transistor 44, and the reset transistor 46 each have a control terminal, an input terminal, and an output terminal. The control terminal is the gate, for example. The input terminal is one of either the drain or the source, typically the drain. The output terminal is the other of either the drain or the source, typically the source.

Note that the "semiconductor substrate" in this specification is not limited to a substrate that is entirely a semiconductor, and may also be an insulating substrate or the like provided with a semiconductor layer at the surface on the side where the light-sensitive area is formed. One example of the semiconductor substrate is a p-type silicon substrate.

As illustrated in Fig. 9, one of either the input terminal or the output terminal of the amplifying transistor 42 and one of either the input terminal or the output terminal of the address transistor 44 are connected. The control terminal of the amplifying transistor 42 is electrically connected to the first electrode 2 of the photoelectric converter 10C. Signal charges collected by the first electrode 2 are stored in a charge storage node 41 between the first electrode 2 and the gate of the amplifying transistor 42. In the present embodiment, the signal charges are holes. The charge storage node 41 is an example of charge storage, and is also referred to as a "floating diffusion node". Note that in the case where the photoelectric converter 10C is configured as the photoelectric conversion element according to Embodiment 5, the signal charges may be electrons.

A voltage corresponding to the signal charges stored in the charge storage node 41 is applied to the gate of the amplifying transistor 42. The amplifying transistor 42 amplifies this voltage. That is, the amplifying transistor 42 amplifies a signal generated by the photoelectric converter 10C. The voltage amplified by the amplifying transistor 42 is selectively read out as a signal voltage via the address transistor 44.

One of either the source or the drain of the reset transistor 46 is connected to the charge storage node 41, and one of either the source or the drain of the reset transistor 46 has an electrical connection with the first electrode 2.

The reset transistor 46 resets the signal charges stored in the charge storage node 41. In other words, the reset transistor 46 resets the potential of the gate of the amplifying transistor 42 and the first electrode 2.

As illustrated in Fig. 9, the imaging apparatus 100 includes a power supply line 23, a vertical signal line 24, an address signal line 25, and a reset signal line 26. These lines are connected to each pixel 20. The power supply line 23 is connected to one of either the source or the drain of the amplifying transistor 42, and supplies a predetermined power supply voltage to each pixel 20. The power supply line 23 functions as a source follower power supply. The vertical signal line 24 is connected to either the source or the drain of the address transistor 44, whichever is not connected to the source or the drain of the amplifying transistor 42. The address signal line 25 is connected to the gate of the address transistor 44. The reset signal line 26 is connected to the gate of the reset transistor 46.

The peripheral circuits of the imaging apparatus 100 include a vertical scan circuit 52, a horizontal signal readout circuit 54, column signal processing circuits 56, load circuits 58, and inverting amplifiers 59. The vertical scan circuit 52 is also referred to as a "row scan circuit", the horizontal signal readout circuit 54 is also referred to as a "column scan circuit", and the column signal processing circuits 56 are also referred to as "row signal storage circuits". The column signal processing circuits 56, the load circuits 58, and the inverting amplifiers 59 are provided in correspondence with each column of the pixels 20 arrayed in the row and column directions. Each of the column signal processing circuits 56 is electrically connected to the pixels 20 disposed in a corresponding column of the pixels 20 via the vertical signal line 24 corresponding to that column. The column signal processing circuits 56 are electrically connected to the horizontal signal readout circuit 54. Each of the load circuits 58 is electrically connected to a corresponding vertical signal line 24, and a source follower circuit is formed by the load circuit 58 and the amplifying transistor 42.

The vertical scan circuit 52 is connected to the address signal line 25 and the reset signal line 26. The vertical scan circuit 52 applies, to the gate of the address transistor 44 via the address signal line 25, a row select signal for controlling the address transistor 44 on and off. The row to be read out is scanned and selected by sending out the row select signal on each address signal line 25. Signal voltages are read out to the vertical signal lines 24 from the pixels 20 in the selected row. In addition, the vertical scan circuit 52 applies, to the gate of the reset transistor 46 via the reset signal line 26, a reset signal for controlling the reset transistor 46 on and off. The row of pixels 20 to be reset is selected by sending out the row select signal on each reset signal line 26. In this way, the vertical scan circuit 52 selects pixels 20 in units of rows to read out the signal voltage and reset the potential of the first electrode 2.

The signal voltages read out from the pixels 20 selected by the vertical scan circuit 52 are sent to the column signal processing circuits 56 via the vertical signal lines 24. The column signal processing circuits 56 perform noise suppression signal processing, as typified by correlated double sampling, analog-to-digital conversion (AD conversion), and the like. The horizontal signal readout circuit 54 sequentially reads out the signals from the column signal processing circuits 56 to a horizontal common signal line, which is not illustrated.

Note that the vertical scan circuit 52 may also partially include the voltage supply circuit 30 described above. Alternatively, the voltage supply circuit 30 may have an electrical connection with the vertical scan circuit 52. In other words, the bias voltage may also be applied to the second electrode 3 via the vertical scan circuit 52.

In the configuration illustrated as an example in Fig. 9, the inverting amplifiers 59 are provided in correspondence with the columns. The input terminal on the negative side of each inverting amplifier 59 is connected to a corresponding vertical signal line 24. The output terminal of each inverting amplifier 59 is connected to the pixels 20 in the corresponding column via a feedback line 27 provided in correspondence with each column.

As illustrated in Fig. 9, the feedback line 27 is connected to either the source or the drain of the reset transistor 46, whichever is not connected to the charge storage node 41 (the drain, for example). Consequently, the inverting amplifier 59 receives the output of the address transistor 44 at the negative terminal when the address transistor 44 and the reset transistor 46 are in a state of continuity. On the other hand, a reference voltage at reset is applied to the input terminal on the positive side of the inverting amplifier 59 from a power supply, which is not illustrated. The inverting amplifier 59 performs a feedback operation such that the gate voltage of the amplifying transistor 42 becomes a predetermined feedback voltage. The feedback voltage means the output voltage of the inverting amplifier 59. The output voltage of the inverting amplifier 59 is, for example, 0 V or a positive voltage near 0 V. The inverting amplifier 59 may also be referred to as a "feedback amplifier".

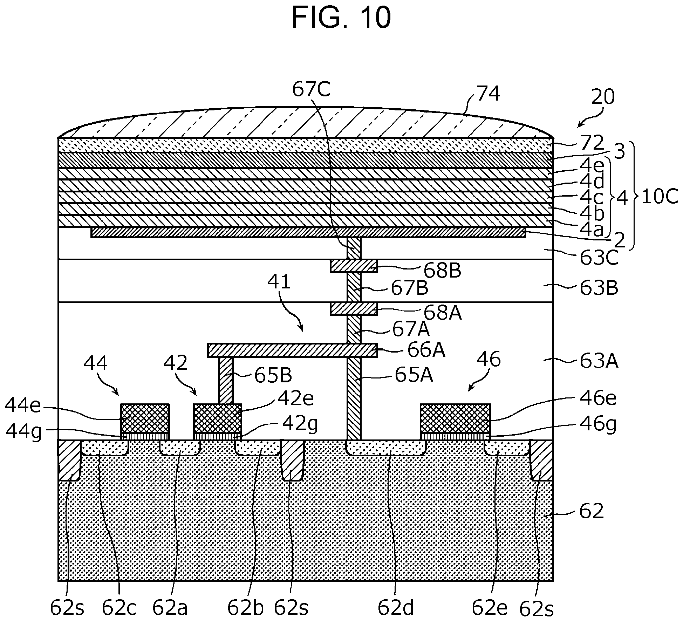

Fig. 10 is a cross section schematically illustrating the device structure of a pixel 20 in the imaging apparatus 100 according to the present embodiment. In the configuration illustrated as an example in Fig. 10, the pixel 20 includes a semiconductor substrate 62 that supports the photoelectric converter 10C. The semiconductor substrate 62 is a silicon substrate, for example. As illustrated in Fig. 10, the photoelectric converter 10C is disposed above the semiconductor substrate 62. In the imaging apparatus 100, light is incident on the photoelectric converter 10C from above the photoelectric converter 10C. That is, light is incident from the second electrode 3 side of the photoelectric converter 10C. In this example, interlayer insulating layers 63A, 63B, 63C are layered on top of the semiconductor substrate 62, and the first electrode 2, the photoelectric conversion layer 4, and the second electrode 3 are layered in that order on top of the interlayer insulating layer 63C. The first electrode 2 is section by pixel such that the first electrodes 2 in two adjacent pixels 20 are formed to be spatially separated from each other, whereby the two adjacent first electrodes 2 are electrically isolated. The photoelectric conversion layer 4 and the second electrode 3 may be formed straddling across multiple pixels 20.

The amplifying transistor 42, the address transistor 44, and the reset transistor 46 are formed in/on the semiconductor substrate 62.

The amplifying transistor 42 includes impurity regions 62a, 62b formed in the semiconductor substrate 62, a gate insulating layer 42g located on top of the semiconductor substrate 62, and a gate electrode 42e located on top of the gate insulating layer 42g. The impurity regions 62a, 62b function as the drain or the source of the amplifying transistor 42. The impurity regions 62a, 62b and impurity regions 62c, 62d, 62e described later are n-type impurity regions, for example.

The address transistor 44 includes impurity regions 62a, 62c formed in the semiconductor substrate 62, a gate insulating layer 44g located on top of the semiconductor substrate 62, and a gate electrode 44e located on top of the gate insulating layer 44g. The impurity regions 62a, 62c function as the drain or the source of the address transistor 44. In this example, the amplifying transistor 42 and the address transistor 44 share the impurity region 62a, whereby the source (or drain) of the amplifying transistor 42 and the drain (or source) of the address transistor 44 are electrically connected.

The reset transistor 46 includes impurity regions 62d, 62e formed inside the semiconductor substrate 62, a gate insulating layer 46g located on top of the semiconductor substrate 62, and a gate electrode 46e located on top of the gate insulating layer 46g. The impurity regions 62d, 62e function as the drain or the source of the reset transistor 46.

In the semiconductor substrate 62, isolation regions 62s are provided between adjacent pixels 20 and between the amplifying transistor 42 and the reset transistor 46. These isolation regions 62s cause adjacent pixels 20 to be electrical isolated from each other. In addition, providing the isolation regions 62s between adjacent pixels 20 suppresses the leakage of signal charges stored in the charge storage node 41.

Within the interlayer insulating layer 63A, a contact plug 65A connected to the impurity region 62d of the reset transistor 46, a contact plug 65B connected to the gate electrode 42e of the amplifying transistor 42, and an interconnect 66A connecting the contact plug 65A with the contact plug 65B are formed. With this arrangement, the impurity region 62d (the drain, for example) of the reset transistor 46 is electrically connected to the gate electrode 42e of the amplifying transistor 42. In the configuration illustrated as an example in Fig. 10, a plug 67A and an interconnect 68A are further formed within the interlayer insulating layer 63A. Additionally, a plug 67B and an interconnect 68B are formed within the interlayer insulating layer 63B and a plug 67C is formed within the interlayer insulating layer 63C, whereby the interconnect 66A and the first electrode 2 are electrically connected. The contact plug 65A, the contact plug 65B, the interconnect 66A, the plug 67A, the interconnect 68A, the plug 67B, the interconnect 68B, and the plug 67C are typically formed from metal.

In the configuration illustrated as an example in Fig. 10, a protective layer 72 is disposed on top of the second electrode 3. The protective layer 72 is not a substrate disposed to support the photoelectric converter 10C. The protective layer 72 is a layer for protecting and insulating the photoelectric converter 10C from others. The protective layer 72 may also be highly light-transmissive for wavelengths that the photoelectric conversion layer 4 absorbs. The material of the protective layer 72 may be any light-transmissive insulator, such as SiON or AlO, for example. As illustrated in Fig. 10, a microlens 74 may also be disposed on top of the protective layer 72.

In the present embodiment, the photoelectric converter 10C is an example of a photoelectric conversion element, and is configured as the photoelectric conversion element according to any of Embodiments 1 to 5. For example, as illustrated in Fig. 10, the photoelectric converter 10C has a similar structure to the photoelectric conversion element 10A described above. The second electrode 3 is disposed above the photoelectric conversion layer 4, or in other words, on the light-incident side of the imaging apparatus 100 relative to the photoelectric conversion layer 4. Light is incident on the photoelectric conversion layer 4 through the second electrode 3.

Note that the photoelectric converter 10C may also have a similar structure to the photoelectric conversion element 10B described above, and may also have a structure that is not provided with one of either the electron blocking layer 5 or the hole blocking layer 6 of the photoelectric conversion element 10B described above. In these cases, too, the signal detection circuit 40 is connected to the first electrode 2, and the voltage supply circuit 30 supplies a voltage to the second electrode 3 via the storage control line 22.

The imaging apparatus 100 as described above can be manufacturing using common semiconductor manufacturing processes. In particular, in the case of using a silicon substrate as the semiconductor substrate 62, manufacturing is possible by utilizing any of various silicon semiconductor processes.

Since the photoelectric conversion element according to any of Embodiments 1 to 5 is used in the imaging apparatus 100 according to the present embodiment, both an expansion of the sensitivity wavelength region and an improvement in sensitivity can be achieved in the imaging apparatus 100. Therefore, the imaging apparatus 100 is capable of imaging light over a broad wavelength region with low noise.

(Other embodiments)

The foregoing describes a photoelectric conversion element and an imaging apparatus according to the present disclosure on the basis of embodiments, but the present disclosure is not limited to the above embodiments. Different aspects constructed by applying various modifications that may occur to a person skilled in the art to the embodiments or by combining some of the structural elements in the embodiments are also included in the scope of the present disclosure, insofar as such aspects do not depart from the gist of the present disclosure.

For example, the above embodiments primarily describe an example of layering n quantum dot layers with mutually different band gap energies and absorption wavelengths by altering the particle diameter of the quantum dots in each of the quantum dot layers, but the present disclosure is not limited thereto. It is also possible to layer n quantum dot layers with mutually different band gap energies and absorption wavelengths by changing the constituent element of the quantum dots in each of the quantum dot layers.

The photoelectric conversion element and imaging apparatus according to the above embodiments are described as being configured such that light is incident from the second electrode side, but the photoelectric conversion element and imaging apparatus may also be configured such that light is incident from the first electrode side.

As an example, the photoelectric conversion element according to the present disclosure may be used in a solar cell by extracting the charges generated by light as energy. The photoelectric conversion element according to the present disclosure may also be used in an optical sensor by extracting the charges generated by light as a signal.

Industrial Applicability

The photoelectric conversion element and imaging apparatus according to the present disclosure are applicable to photodiodes, image sensors, and the like, and are particularly applicable to optical sensing with high sensitivity and low dark current using infrared wavelengths.

Reference Signs List

1 substrate
2 first electrode
3 second electrode
4, 4X photoelectric conversion layer
4a first quantum dot layer
4b second quantum dot layer

4c third quantum dot layer
4d fourth quantum dot layer
4e fifth quantum dot layer
5 electron blocking layer
6 hole blocking layer
10A, 10B photoelectric conversion element
10C photoelectric converter
20 pixel
22 storage control line
23 power supply line
24 vertical signal line
25 address signal line
26 reset signal line
27 feedback line
30 voltage supply circuit
40 signal detection circuit
41 charge storage node
42 amplifying transistor
42e, 44e, 46e gate electrode
42g, 44g, 46g gate insulating layer
44 address transistor
46 reset transistor
52 vertical scan circuit
54 horizontal signal readout circuit
56 column signal processing circuit
58 load circuit
59 inverting amplifier
62 semiconductor substrate
62a, 62b, 62c, 62d, 62e impurity region
62s isolation region
63A, 63B, 63C interlayer insulating layer
65A, 65B contact plug
66A interconnect
67A, 67B, 67C plug
68A, 68B interconnect
72 protective layer
74 microlens
100 imaging apparatus

**Claims**

1. A photoelectric conversion element comprising:

    a photoelectric conversion layer;
    a first electrode that collects holes produced in the photoelectric conversion layer as signal charges; and
    a second electrode that faces the first electrode across the photoelectric conversion layer and that collects electrons produced in the photoelectric conversion layer, wherein
    the photoelectric conversion layer includes three or more quantum dot layers layered onto one another,
    each of the three or more quantum dot layers contains quantum dots and surface-modifying ligands modifying the surfaces of the quantum dots,
    a band gap energy of a quantum dot layer closer to the first electrode is lower than a band gap energy of a quantum dot layer closer to the second electrode in at least one combination of two adjacent quantum dot layers among the three or more quantum dot layers, and
    an energy relationship at an interface between each of the three or more quantum dot layers and a quantum dot layer adjacent to each of the three or more quantum dot layers satisfies at least one of Expression (1) and Expression (2) below:

$$E_{i+1}{}^{CBM} - E_i{}^{CBM} \geq 0 \qquad (1)$$

$$E_{i+1}{}^{VBM} - E_i{}^{VBM} \geq 0 \qquad (2)$$

where

$E_i{}^{CBM}$ is an energy of a lower end of a conduction band of an i-th quantum dot layer of the three or more quantum dot layers, counting from the first electrode,
$E_{i+i}{}^{CBM}$ is an energy of a lower end of a conduction band of an (i+1)-th quantum dot layer of the three or more quantum dot layers, counting from the first electrode,
$E_i{}^{VBM}$ is an energy of an upper end of a valence band of the i-th quantum dot layer of the three or more quantum dot layers, counting from the first electrode, and
$E_{i+i}{}^{VBM}$ is an energy of an upper end of a valence band of the (i+1)-th quantum dot layer of the three or more quantum dot layers, counting from the first electrode.

2. The photoelectric conversion element according to claim 1, wherein the energy relationship at the interface satisfies both Expression (1) and Expression (2).

3. The photoelectric conversion element according to claim 1 or 2, wherein the energy relationship at the interface satisfies Expression (3) below:

$$E_i{}^{VBM} - E_{i+1}{}^{CBM} > 0 \qquad (3).$$

4. A photoelectric conversion element comprising:

a photoelectric conversion layer;
a first electrode that collects electrons produced in the photoelectric conversion layer as signal charges; and
a second electrode that faces the first electrode across the photoelectric conversion layer and that collects holes produced in the photoelectric conversion layer, wherein
the photoelectric conversion layer includes three or more quantum dot layers layered onto one another,
each of the three or more quantum dot layers contains quantum dots,
a band gap energy of a quantum dot layer closer to the first electrode is lower than a band gap energy of a quantum dot layer closer to the second electrode in at least one combination of two adjacent quantum dot layers among the three or more quantum dot layers, and
an energy relationship at an interface between each of the three or more quantum dot layers and a quantum dot layer adjacent to each of the three or more quantum dot layers satisfies at least one of Expression (4) and Expression (5) below:

$$E_i{}^{CBM} - E_{i+1}{}^{CBM} \geq 0 \qquad (4)$$

$$E_i{}^{VBM} - E_{i+1}{}^{VBM} \geq 0 \qquad (5)$$

where

$E_i{}^{CBM}$ is an energy of a lower end of a conduction band of an i-th quantum dot layer of the three or more quantum dot layers, counting from the first electrode,
$E_{i+1}{}^{CBM}$ is an energy of a lower end of a conduction band of an (i+1)-th quantum dot layer of the three or more quantum dot layers, counting from the first electrode,
$E_i{}^{VBM}$ is an energy of an upper end of a valence band of the i-th quantum dot layer of the three or more quantum dot layers, counting from the first electrode, and
$E_{i+1}{}^{VBM}$ is an energy of an upper end of a valence band of the (i+1)-th quantum dot layer of the three or more quantum dot layers, counting from the first electrode.

5. The photoelectric conversion element according to claim 4, wherein the energy relationship at the interface satisfies both Expression (4) and Expression (5).

6. The photoelectric conversion element according to claim 4 or 5, wherein the energy relationship at the interface satisfies Expression (6) below:

$$E_{i+1}^{VBM} - E_i^{CBM} > 0 \qquad (6).$$

7. The photoelectric conversion element according to any one of claims 1 to 6, wherein in the three or more quantum dot layers, a potential gradient for the signal charges is equal to or greater than a potential gradient for charges of opposite polarity to the signal charges.

8. The photoelectric conversion element according to any one of claims 1 to 7, wherein out of two adjacent quantum dot layers among the three or more quantum dot layers, a particle diameter of quantum dots contained in the quantum dot layer closer to the second electrode is less than a particle diameter of quantum dots contained in the quantum dot layer closer to the first electrode.

9. The photoelectric conversion element according to any one of claims 1 to 7, wherein out of two adjacent quantum dot layers among the three or more quantum dot layers, an absorption peak wavelength of the quantum dot layer closer to the second electrode is shorter than an absorption peak wavelength of the quantum dot layer closer to the first electrode.

10. The photoelectric conversion element according to any one of claims 1 to 3, wherein the surface-modifying ligands contained in at least two of the three or more quantum dot layers are mutually different.

11. The photoelectric conversion element according to any one of claims 1 to 3, wherein densities of the surface-modifying ligands contained in at least two of the three or more quantum dot layers are mutually different.

12. The photoelectric conversion element according to any one of claims 4 to 6, wherein

   each of the three or more quantum dot layers further contains surface-modifying ligands modifying surfaces of the quantum dots, and
   the surface-modifying ligands contained in at least two of the three or more quantum dot layers are mutually different.

13. The photoelectric conversion element according to any one of claims 4 to 6, wherein

   each of the three or more quantum dot layers further contains surface-modifying ligands modifying surfaces of the quantum dots, and
   densities of the surface-modifying ligands contained in at least two of the three or more quantum dot layers are mutually different.

14. The photoelectric conversion element according to any one of claims 1 to 13, wherein the quantum dots include at least one selected from the group consisting of CdSe, CdS, PbS, PbSe, PbTe, ZnO, ZnS, $Cu_2ZnSnS_4$, $Cu_2S$, $CuInSe_2$, $AgInS_2$, $AgInTe_2$, $CdSnAs_2$, $ZnSnAs_2$, $ZnSnSb_2$, $Bi_2S_3$, $Ag_2S$, $Ag_2Te$, $AgBiS_2$, AgAuS, HgTe, CdHgTe, Ge, GeSn, InAs, and InSb.

15. An imaging apparatus comprising:

   a plurality of pixels, each including the photoelectric conversion element according to any one of claims 1 to 14;
   a signal readout circuit connected to the first electrode; and
   a voltage supply circuit that supplies a voltage to the second electrode.

# FIG. 1

# FIG. 2A

# FIG. 2B

## FIG. 3

## FIG. 4A

## FIG. 4B

## FIG. 5

# FIG. 6

## FIG. 7A

## FIG. 7B

# FIG. 7C

INCIDENT LIGHT INTENSITY

INCIDENT LIGHT

3
4e
4d
4c
4b
4a
2
4

λ5  λ4  λ3  λ2  λ1

# FIG. 7D

INCIDENT LIGHT INTENSITY

INCIDENT LIGHT

3
4a
4b
4c
4d
4e
2
4X

λ5  λ4  λ3  λ2  λ1

# FIG. 8

# FIG. 9

# FIG. 10

## INTERNATIONAL SEARCH REPORT

| International application No. |
| --- |
| **PCT/JP2023/001179** |

### A. CLASSIFICATION OF SUBJECT MATTER

*H01L 31/10*(2006.01)i; *H01L 27/146*(2006.01)i
FI: H01L31/10 A; H01L27/146 E

According to International Patent Classification (IPC) or to both national classification and IPC

### B. FIELDS SEARCHED

Minimum documentation searched (classification system followed by classification symbols)

H01L31/00-31/20; H01L27/14-27/148; H10K30/00-39/38

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JST7580 (JDreamIII)

### C. DOCUMENTS CONSIDERED TO BE RELEVANT

| Category* | Citation of document, with indication, where appropriate, of the relevant passages | Relevant to claim No. |
| --- | --- | --- |
| Y | US 2018/0254421 A1 (TOYOTA MOTOR EUROPE) 06 September 2018 (2018-09-06) paragraphs [0001]-[0072], fig. 1A-2B | 1-15 |
| Y | US 2017/0025466 A1 (ARTILUX CORP.) 26 January 2017 (2017-01-26) paragraphs [0032]-[0037], fig. 1A-1B | 1-15 |
| Y | JP 2017-516320 A (MASSACHUSETTS INSTITUTE OF TECHNOLOGY) 15 June 2017 (2017-06-15) paragraph [0035], fig. 1A-1E, 6A | 1-15 |
| Y | CN 111477644 A (SOUTHEAST UNIVERSITY) 31 July 2020 (2020-07-31) paragraphs [0035]-[0063], fig. 1-5(c) | 1-15 |
| Y | US 2015/0357534 A1 (THE BOARD OF TRUSTEES OF THE LELAND STANFORD JUNIOR UNIVERSITY) 10 December 2015 (2015-12-10) paragraphs [0001], [0014], [0022], [0037]-[0051], fig. 7a-15b | 1–15 |
| Y | HOU, Bo et al., "Highly Monodispersed PbS Quantum Dots for Outstanding Cascaded-Junction Solar Cells", ACS Energy Letters, 2016, vol. 1, pp. 834-839 in particular, p. 834, right column, line 1 to p. 835, left column, line 10, fig. 1 | 4-15 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **20 March 2023** | **04 April 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2023/001179**

| Patent document cited in search report | | | Publication date (day/month/year) | Patent family member(s) | | | Publication date (day/month/year) |
|---|---|---|---|---|---|---|---|
| US | 2018/0254421 | A1 | 06 September 2018 | WO | 2017/054887 | A1 | |
| | | | | CN | 108352451 | A | |
| US | 2017/0025466 | A1 | 26 January 2017 | WO | 2017/015580 | A1 | |
| | | | | EP | 3734661 | A2 | |
| | | | | CN | 108352393 | A | |
| JP | 2017-516320 | A | 15 June 2017 | US | 2017/0271604 | A1 | |
| | | | | paragraph [0054], fig. 1A-1E, fig. 6A | | | |
| | | | | WO | 2015/172019 | A1 | |
| | | | | CA | 2948486 | A1 | |
| | | | | KR | 10-2017-0028306 | A | |
| | | | | CN | 106660784 | A | |
| CN | 111477644 | A | 31 July 2020 | (Family: none) | | | |
| US | 2015/0357534 | A1 | 10 December 2015 | (Family: none) | | | |

Form PCT/ISA/210 (patent family annex) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Highly Monodispersed PbS Quantum Dots for Outstanding Cascaded-Junction Solar Cells. **BO HOU et al.** ACS Energy Lettes. American Chemical Society, 2016, vol. 1, 834-839

- Energy Level Modification in Lead Sulfide Quantum Dot Thin Films through Ligand Exchange. **PATRICK R. BROWN et al.** ACS Nano. American Chemical Society, 2014, vol. 8, 5863-5872